# EUROPEAN PATENT APPLICATION

(11) **EP 4 534 608 A1**
(43) Date of publication of application: **09.04.2025**
(21) Application number: 23816097.2
(22) Date of filing: 31.05.2023
(51) Int. Cl.: C08L 101/06, C08G 59/40, H01L 23/29, H01L 23/31

(54) **EASILY DETACHABLE THERMOSETTING RESIN COMPOSITION AND DETACHING METHOD**

(30) Priority: 31.05.2022 JP 2022088784
(71) Applicant: Sumitomo Bakelite Co., Ltd., Shinagawa-ku Tokyo 140-0002 (JP)
(72) Inventor: MAKIHARA, Koji, Tokyo 140-0002 (JP); KUMAMOTO, Tsuneaki, Tokyo 140-0002 (JP); HASHIZUME, Masayoshi, Tokyo 140-0002 (JP)
(74) Representative: Müller-Boré & Partner Patentanwälte PartG mbB
(86) International application number: PCT/JP2023/020245
(87) International publication number: WO 2023/234340

(57) **Abstract**

An easily dismantlable thermosetting resin composition according to the present invention contains a thermosetting component; and a cured product which is obtained by thermally curing this thermosetting resin composition has a structure represented by Formula (1).

## Description

### TECHNICAL FIELD

The present invention relates to an easily dismantlable thermosetting resin composition and a dismantling method. More specifically, the present invention relates to an easily dismantlable thermosetting resin composition, a structural body including a cured product of the easily dismantlable thermosetting resin composition, a semiconductor device including a cured product of the easily dismantlable thermosetting resin composition, a dismantling method for a cured product of the easily dismantlable thermosetting resin composition, and a recycling method for a material that constitutes the rotor.

### BACKGROUND ART

In recent years, from the viewpoint of weight reduction, a structure such as an automobile tends to use lightweight metals such as aluminum, a resin, or the like instead of iron, and the combination of these metals with cured materials of thermosetting resins is progressing. On the other hand, in order to accelerate an effective use of resources such as metals, research and development for separating and recovering metals from waste materials of composite members used in automobiles and the like and reusing the recovered materials are actively carried out. Therefore, it is important to recover metals from the composite members by removing the cured product of the thermosetting resin while suppressing damage to the metals.

For example, Patent Document 1 discloses a treatment liquid that is capable of efficiently decomposing and dissolving a cured product of a thermosetting resin composition at a low temperature, in order to recover carbon fibers from a carbon fiber-reinforced plastic in which carbon fibers are used as a reinforcing material, or in order to recover a semiconductor element or the like from a semiconductor package obtained by sealing a semiconductor element with an epoxy resin cured product (sealing resin).

### RELATED DOCUMENT

### PATENT DOCUMENT

[Patent Document 1] Japanese Unexamined Patent Publication No. 2020-50689

### SUMMARY OF THE INVENTION

### TECHNICAL PROBLEM

However, such a method of decomposing a cured product of a thermosetting resin composition, as disclosed in Patent Document **1,** is a method that focuses on the treatment liquid for decomposition, and it does not disclose the technical idea for the decomposability and the dismantlability of the thermosetting resin composition itself.

As a result of intensive studies focusing on the dismantlability of the thermosetting resin composition itself, the inventors of the present invention have found that it is effective for a cured product of a thermosetting resin composition to have a predetermined structure. That is, it is considered that in a case where a cured product of the thermosetting resin composition is subjected to a solution treatment, the predetermined structural portion is easily detached, whereby the network in the cured product is divided, and the cured product is easily dismantled.

### SOLUTION TO PROBLEM

The present invention provides the followings: an easily dismantlable thermosetting resin composition, a structural body including a cured product of the easily dismantlable thermosetting resin composition, a semiconductor device including a cured product of the easily dismantlable thermosetting resin composition, a dismantling method for a cured product of the easily dismantlable thermosetting resin composition, and a recycling method for a material that constitutes the rotor.

[1] An easily dismantlable thermosetting resin composition containing:
   a thermosetting component,
   in which in the easily dismantlable thermosetting resin composition, a cured product which is obtained by thermally curing the easily dismantlable thermosetting resin composition has a structure represented by Formula (1), 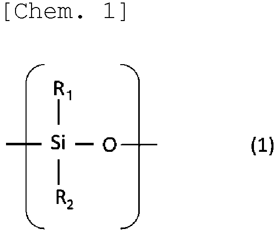 (In Formula (1), R₁ and R₂ each independently represent any of a hydrogen atom, a hydrocarbon group or aromatic group having 1 to 30 carbon atoms, a hydroxyl group, and an alkoxyl group having 1 to 30 carbon atoms).
[2] The easily dismantlable thermosetting resin composition according to [1], in which the thermosetting component has an - Si-O- structure.
[3] The easily dismantlable thermosetting resin composition according to [1] or [2], in which the thermosetting component contains a thermosetting resin and a curing agent, and both the thermosetting component and the curing agent have an -Si-O-structure.
[4] The easily dismantlable thermosetting resin composition according to [1] or [2], in which the thermosetting component contains a thermosetting resin and a curing agent, and the curing agent has an -Si-O- structure.
[5] The easily dismantlable thermosetting resin composition according to [1] or [2], in which the thermosetting component contains a thermosetting resin and a curing agent, and the thermosetting resin has an -Si-O- structure.
[6] The easily dismantlable thermosetting resin composition according to any one of [3] to [5], in which the curing agent includes a phenol-based curing agent.
[7] The easily dismantlable thermosetting resin composition according to any one of [3] to [6], in which the thermosetting resin includes one or two or more resins selected from an epoxy resin, a phenoxy resin, a polyimide resin, a benzoxazine resin, an unsaturated polyester resin, a phenol resin, a melamine resin, a silicone resin, a cyanate resin, a bismaleimide resin, and an acrylic resin.
[8] The easily dismantlable thermosetting resin composition according to [7], in which the thermosetting resin includes an epoxy resin.
[9] The easily dismantlable thermosetting resin composition according to any one of [1] to [8], further containing:
   an inorganic filler, in which a content of the inorganic filler is 10% by mass to 98% by mass with respect to a total amount of the easily dismantlable thermosetting resin composition.
[10] The easily dismantlable thermosetting resin composition according to any one of [1] to [9], in which the easily dismantlable thermosetting resin composition contains a silyl ether-modified novolac resin.
[11] The easily dismantlable thermosetting resin composition according to any one of [1] to [10], in which the easily dismantlable thermosetting resin composition contains a phenol resin having a weight average molecular weight (Mw) of 500 to 10,000.
[12] A structural body including:
   a cured product of the easily dismantlable thermosetting resin composition according to any one of [1] to [11].
[13] A semiconductor device including:
   a semiconductor element; and
   a sealing material that seals the semiconductor element, in which the sealing material consists of the cured product of the easily dismantlable thermosetting resin composition according to any one of [1] to [11].
[14] A dismantling method that is a dismantling method for the cured product of the easily dismantlable thermosetting resin composition according to any one of [1] to [11], the dismantling method including:
   a step of immersing the cured product of the easily dismantlable thermosetting resin composition in a solvent to dismantle the cured product.
[15] The dismantling method according to [14], in which in the dismantling method, the solvent is a solvent containing a fluorine ion.
[16] The dismantling method according to [14] or [15], in which in the dismantling method, the immersion is carried out at -20°C to 200°C.
[17] The dismantling method according to any one of [14] to [16], in which in the dismantling method, the immersion is carried out at 5°C to 30°C.
[18] A recycling method for a material that constitutes the structural body according to [12], the recycling method including:
   a step of immersing the structural body in a solvent to dismantle the cured product of the easily dismantlable thermosetting resin composition; and
   a step of recovering the material from the structural body.

### ADVANTAGEOUS EFFECTS OF INVENTION

According to the present invention, the recyclability of resources can be improved by the easy dismantlability of the cured product of the thermosetting resin composition.

### DESCRIPTION OF EMBODIMENTS

In the present specification, a denotation "a to b" in the description of a numerical value range represents a or more and b or less unless specified otherwise. For example, "1% by mass to 5% by mass" means "1% by mass or more and 5% by mass or less". In addition, the lower limit value and the upper limit value of the numerical value range can be respectively combined with the lower limit value and the upper limit value of other numerical value ranges.

Each component and material exemplified in the present specification may be used alone or may be used in a combination of two or more kinds thereof, unless otherwise specified.

In a denotation of a group (atomic group) in the present specification, a denotation that does not indicate whether a group is substituted or unsubstituted includes both a group having no substituent and a group having a substituent. For example, an "alkyl group" includes not only an alkyl group having no substituent (unsubstituted alkyl group) but also an alkyl group having a substituent (substituted alkyl group).

In addition, in a denotation of a group (atomic group) in the present specification, a denotation that does not indicate where a group is linear, branched, or cyclic, may indicate any of linear, branched, or cyclic.

Unless otherwise specified, the term "organic group" in the present specification means an atomic group obtained by removing one or more hydrogen atoms from an organic compound. For example, the "monovalent organic group" indicates an atomic group obtained by removing one hydrogen atom from any organic compound.

Hereinafter, embodiments of the present invention will be described in detail.

### 1. Easily dismantlable thermosetting resin composition

An easily dismantlable thermosetting resin composition according to the present embodiment (hereinafter, also simply referred to as a "resin composition") contains a thermosetting component, and a cured product which is obtained by thermally curing the resin composition has a structure represented by Formula (1) below. In addition, it is favorable that the conditions for the above-described thermal curing are set to 175°C for 2 minutes. 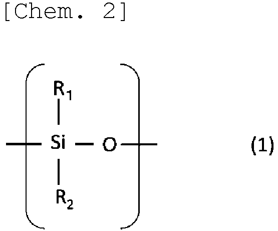 (In Formula (1), R₁ and R₂ each independently represent any of a hydrogen atom, a hydrocarbon group or aromatic group having 1 to 30 carbon atoms, a hydroxyl group, and an alkoxyl group having 1 to 30 carbon atoms).

As a result, in a case where the cured product of the resin composition according to the present embodiment is subjected to a solution treatment, a structure of Formula (1) is detached, a crosslinking structure in the cured product is broken, and thus easy dismantlability is obtained.

The structure of Formula (1) may be a structure that is formed by a thermosetting reaction of the thermosetting component.

In the present embodiment, the "easy dismantlability" is intended to mean that a cured product is subjected to gel decomposition, thereby being dissolved in a case where the cured product is subjected to a solution treatment.

In addition, the presence or absence of the structure represented by Formula (1) in the cured product can be checked, for example, by a general analysis method such as gas chromatography, high-performance liquid chromatography, thin-layer chromatography, NMR, or IR. The analysis target subjected to checking may be an analysis target in a state of a cured product or may be a decomposition liquid that is obtained by decomposing a cured product. From the viewpoint that the state of the cured product can be checked, a gas chromatography-mass spectrometry (GC-MS) method is preferable. In addition, the analysis target may be a decomposition treatment liquid of a cured product from the viewpoint that, for example, the structure thereof is easily distinguishable from a structure due to a coupling agent, which will be described later.

In addition, the cured product according to the present embodiment preferably has the structure of Formula (1) as a repeating unit. The number of repetitions is not particularly limited; however, the average number of repetitions may be 5 to 1,500.

In Formula (1), R₁ and R₂ each independently represent any of a hydrogen atom, a hydrocarbon group or aromatic group having 1 to 30 carbon atoms, a hydroxyl group, and an alkoxyl group having 1 to 30 carbon atoms.

The hydrocarbon group having 1 to 30 carbon atoms may be either linear, branched, or cyclic, and may or may not have a substituent.

The hydrocarbon group having 1 to 30 carbon atoms is preferably a linear alkyl, alkenyl, or alkynyl group having 1 to 20 carbon atoms, and more preferably a linear alkyl, alkenyl, or alkynyl group having 1 to 10 carbon atoms.

The branched hydrocarbon group having 3 to 20 carbon atoms is preferably a branched alkyl, alkenyl, or alkynyl group having 3 to 20 carbon atoms, more preferably a branched alkyl, alkenyl, or alkynyl group having 3 to 10 carbon atoms, and still more preferably a branched alkyl, alkenyl, or alkynyl group having 3 to 6 carbon atoms.

The cyclic hydrocarbon group having 3 to 20 carbon atoms is preferably a cycloalkyl, cycloalkenyl, or cycloalkynyl group having 3 to 20 carbon atoms, and still more preferably a cycloalkenyl or cycloalkynyl group having 5 to 10 carbon atoms. Specific examples thereof include a cyclopropyl group, a cyclobutyl group, a cyclopentyl group, and a cyclohexyl group.

The aromatic group may have a substituent, and examples of the substituent include a hydrocarbon group, a hydroxyl group, a halogen atom, and an amino group.

The alkoxyl group having 1 to 30 carbon atoms is preferably an alkoxyl group having 1 to 10 carbon atoms, and more preferably an alkoxyl group having 1 to 6 carbon atoms. Specific examples thereof include a methoxy group, an ethoxy group, and an isopropoxy group.

The resin composition according to the present embodiment contains a thermosetting component. The thermosetting component needs only to be a thermosetting component that contains a group which is polymerized/crosslinked by the action of an active chemical species such as a radical, and specifically, the thermosetting component may be a thermosetting resin or a curing agent. The resin composition according to the present embodiment may contain only one kind of the thermosetting component or may contain two or more kinds thereof.

The resin composition according to the present embodiment preferably contains a thermosetting resin and a curing agent. In this case, it is preferable that at least one of the thermosetting resin or the curing agent has an -Si-O- structure. As a result, the cured product of the resin composition according to the present embodiment can have a structure represented by Formula (1), and the cured product can be dissolved in a solvent, whereby easy dismantlability is obtained.

In the resin composition according to the present embodiment, various components can be combined so that the cured product has a structure represented by Formula (1). Specific examples thereof include resin compositions having the following forms.

<1> A resin composition containing a phenol resin (P) having an -Si-O- structure.
<2> A resin composition containing a thermosetting resin and, as a curing agent, a phenol resin (P) having an -Si-O-structure.
<3> A resin composition containing an epoxy resin (A) having an -Si-O- structure.
<4> A resin composition containing, as a thermosetting resin, a silicone resin (organopolysiloxane) (C1) having two or more alkenyl groups bonded to a silicon atom in one molecule; and as a curing agent, an organohydrogen polysiloxane (C2) having two or more hydrogen atoms bonded to a silicon atom in one molecule.
<5> A resin composition containing an acrylic/vinyl resin obtained by reacting an unsaturated bond having an -Si-O-structure in a main chain.

Hereinafter, each embodiment will be described in detail.

### <First embodiment>

In the first embodiment, a description will be made regarding a resin composition containing a phenol resin (P) having an -Si-O- structure. In this case, the curing agent may be a curing agent which does not have an -Si-O- structure, or a publicly known curing agent may be used. The publicly known curing agent will be described later.

As the phenol resin (P) having an -Si-O- structure, a phenol resin modified with a silyl ether having a phenolic hydroxyl group can be used. Specific examples thereof include a silyl ether-modified novolac resin represented by Formula (P1).

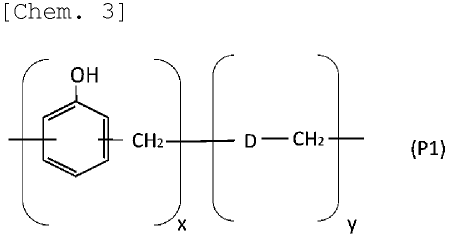

In Formula (P1), x and y are both integers, and x + y is 2 to 200.

In addition, from the viewpoint of obtaining favorable dismantlability and moldability, in Formula (P1), it is preferable to satisfy x:y = 1:99 to 99:1, it is more preferable to satisfy x:y = 2:98 to 75:25, and it is still more preferable to satisfy x:y = 5:95 to 50:50.

In addition, in Formula (P1), D has a structure represented by Formula (P1-1) below.

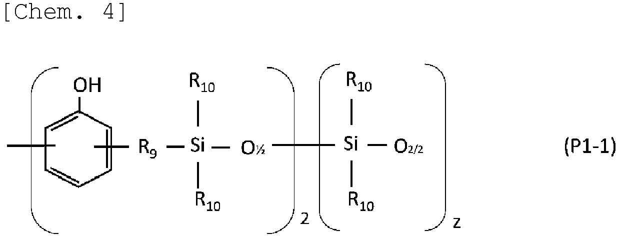

In Formula (P1-1), R₉ represents a divalent hydrocarbon group having 2 to 10 carbon atoms. R₁₀'s each independently represent any of a hydrogen atom, a monovalent hydrocarbon group or aromatic group having 1 to 30 carbon atoms, a hydroxyl group, and an alkoxyl group having 1 to 30 carbon atoms. z is an integer of 0 to 10.

Among these, R₉ is preferably a divalent hydrocarbon group having 2 to 5 carbon atoms, more preferably a divalent hydrocarbon group having 2 to 4 carbon atoms, and still more preferably a propenyl group. R₁₀'s are each independently preferably a monovalent hydrocarbon group having 1 to 20 carbon atoms and are more preferably a monovalent hydrocarbon group having 1 to 10 carbon atoms. In addition, R₁₀'s are more preferably an alkyl group, which is an alkyl group having 1 to 5 carbon atoms, and still more preferably a methyl group.

The weight average molecular weight (Mw) of the phenol resin (P1) is not particularly limited; however, it is preferably 500 to 10,000, more preferably 1,000 to 8,000, and still more preferably 1,500 to 5,000. In addition, the number average molecular weight (Mn) of the phenol resin (P1) is not particularly limited; however, it is preferably 100 to 5,000, more preferably 300 to 3,000, and still more preferably 600 to 1,000.

In the present embodiment, Mw and Mn can be calculated by gel permeation chromatography (GPC).

Regarding a synthesis method for the phenol resin (P), the phenol resin (P) can be synthesized by reacting silyl ethers, phenols, and aldehydes in the presence of an acid catalyst.

The silyl ethers preferably have a phenolic hydroxyl group, and examples thereof include a compound represented by Formula (P1-2) below.

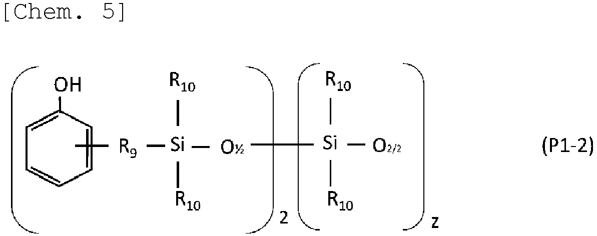

In Formula (P1-2), R₉ represents a divalent hydrocarbon group having 2 to 10 carbon atoms. R₁₀'s each independently represent any of a hydrogen atom, a monovalent hydrocarbon group or aromatic group having 1 to 30 carbon atoms, a hydroxyl group, and an alkoxyl group having 1 to 30 carbon atoms. z is an integer of 0 to 10.

Among these, R₉ is preferably a divalent hydrocarbon group having 2 to 5 carbon atoms, more preferably a divalent hydrocarbon group having 2 to 4 carbon atoms, and still more preferably a propenyl group. R₁₀'s are each independently preferably a monovalent hydrocarbon group having 1 to 20 carbon atoms and is more preferably a monovalent hydrocarbon group having 1 to 10 carbon atoms. In addition, it is preferably an alkyl group, more preferably an alkyl group having 1 to 5 carbon atoms, and still more preferably a methyl group.

Examples of the above-described phenols include, which is not limited to these, phenol; cresols such as ortho-cresol, meta-cresol, and para-cresol; xylenols such as 2,3-xylenol, 2,4-xylenol, 2,5-xylenol, 2,6-xylenol, and 3,5-xylenol; alkyl phenols such as 2,3,5-trimethylphenol, 2-ethylphenol, 4-ethylphenol, 2-isopropylphenol, 4-isopropylphenol, n-butylphenol, isobutylphenol, tert-butylphenol, hexylphenol, octylphenol, nonylphenol, phenylphenol, benzylphenol, cumylphenol, allylphenol, cardanol, urushiol, thitsiol, and laccol; naphthols such as 1-naphthol and 2-naphthol; halogenated phenols such as fluorophenol, chlorophenol, bromophenol, and iodophenol; monohydric phenol substitutes such as p-phenylphenol, aminophenol, nitrophenol, dinitrophenol, and trinitrophenol; and polyhydric phenols such as resorcinol, an alkyl resorcinol, pyrogallol, catechol, an alkyl catechol, hydroquinone, an alkyl hydroquinone, phloroglucin, bisphenol A, bisphenol F, bisphenol S, dihydroxynaphthalene, and naphthalene. These may be used alone or in a combination of two or more kinds thereof. Among these, the phenols can include one or more selected from the group consisting of phenol, cresol, xylenol, and alkyl phenol, and from the viewpoint of low cost, phenol can be used.

The aldehydes are not particularly limited, and examples thereof include formaldehydes such as formalin and para-formaldehyde; trioxane, acetaldehyde, propionaldehyde, polyoxymethylene, chloral, hexamethylenetetramine, furfural, glyoxal, n-butylaldehyde, caproaldehyde, allylaldehyde, benzaldehyde, crotonaldehyde, acrolein, tetraoxymethylene, phenylacetaldehyde, o-tolualdehyde, and salicylaldehyde. These aldehydes may be used alone or in a combination of two or more thereof. Among these, the aldehydes can include formaldehyde or acetaldehyde, and from the viewpoint of productivity and low cost, formalin or para-formaldehyde can be used.

Regarding a catalyst to be used in the synthesis of the phenol resin (P), a catalyst may not be used, or an acidic catalyst can be used from the viewpoint of producing a novolac-type phenol resin. The acidic catalyst is not particularly limited, and examples thereof include acids such as oxalic acid, hydrochloric acid, sulfuric acid, diethyl sulfate, and paratoluenesulfonic acid, and metal salts such as zinc acetate, which can be used alone or in a combination of two or more thereof.

As the reaction solvent to be used in the synthesis of the phenol resin (P), water may be used, or an organic solvent may be used. As the organic solvent, a non-aqueous system can be used by using a non-polar solvent. Examples of the organic solvent include alcohols, ketones, and aromatics. Examples of the alcohols include methanol, ethanol, propyl alcohol, ethylene glycol, diethylene glycol, triethylene glycol, and glycerin, examples of the ketones include acetone and methyl ethyl ketone, and examples of the aromatics include toluene and xylene. These may be used alone or in a combination of two or more kinds thereof.

In addition, regarding the molar ratio (F/P molar ratio) of the phenols (P) to the aldehydes (F) the aldehydes may be set to, for example, 0.2 to 1.0 mol with respect to 1 mol of the phenols and can be preferably set to 0.3 to 0.9 mol. By setting the amount of the aldehydes to be within the above-described range, the amount of unreacted phenol can be reduced, and the yield can be increased.

In addition, the reaction temperature may be set to, for example, 40°C to 120°C and preferably set to 60°C to 110°C. It is noted that the reaction time is not particularly limited, and it only needs to be appropriately determined according to the kind of the starting material, the molar ratio in the blending, the amount and kind of the catalyst to be used, and the reaction conditions.

In such a manner as described above, the phenol resin (P) can be obtained.

### <Second embodiment>

In the second embodiment, a description will be made regarding a case where the phenol resin (P) having an -Si-O-structure is used as a curing agent. In this case, the thermosetting resin may or may not be a thermosetting resin that has an -Si-O- structure; however, in the second embodiment, a description will be made regarding a case where the thermosetting resin does not have an -Si-O- structure. The thermosetting resin is not particularly limited, and a publicly known epoxy resin can be used. The publicly known epoxy resin will be described later.

In addition, the phenol resin (P) as a curing agent and the epoxy resin are adjusted so that an equivalent ratio (EP)/(OH) of the number of epoxy groups (EP) in the total thermosetting resin to the number of phenolic hydroxyl groups (OH) in the total phenol resin is preferably 0.8 or more and 1.6 or less, more preferably 0.9 or more and 1.3 or less, and still more preferably 1.0 or more and 1.2 or less. In a case where the equivalent ratio is within the above-described range, the curing characteristics of the obtainable resin composition according to the present embodiment can be made favorable.

Other components contained in the resin composition according to the second embodiment will be described later.

### <Third embodiment>

In the third embodiment, a description will be made regarding a resin composition containing an epoxy resin (A) having an -Si-O- structure. In this case, the curing agent may or may not be a thermosetting resin that has an -Si-O-structure; however, in the third embodiment, a description will be made regarding a case where the thermosetting resin does not have an Si-O- structure. The curing agent is not particularly limited, and a publicly known curing agent may be used. The publicly known curing agent will be described later.

Specific examples of the epoxy resin (A) having an -Si-O-structure include an epoxy resin (A1) having an -Si-O-structure, which is obtained by epoxidizing the phenol resin (P1) having an -Si-O- structure, which is described in the first embodiment; a bi- or higher functional epoxy compound (A2) having a structure represented by Formula (A2) below; and an organosiloxane-type epoxy compound (A3) having a structure represented by Formula (A3) below.

### [Epoxy resin (A1)]

Examples of the epoxy resin (A1) having an -Si-O-structure, which is obtained by epoxidizing the phenol resin (P1) having an -Si-O- structure include those represented by Formula (A1) below.

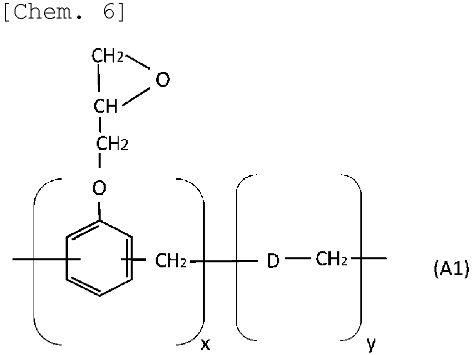

In Formula (A1), x and y are both integers, and x + y is 2 to 200.

In addition, from the viewpoint of obtaining favorable dismantlability and moldability, in Formula (A1), it is preferable to satisfy x:y = 1:99 to 99:1, it is more preferable to satisfy x:y = 2:98 to 75:25, and it is still more preferable to satisfy x:y = 5:95 to 50:50.

In addition, in Formula (A1), D has a structure represented by Formula (A1-1) below.

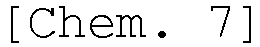

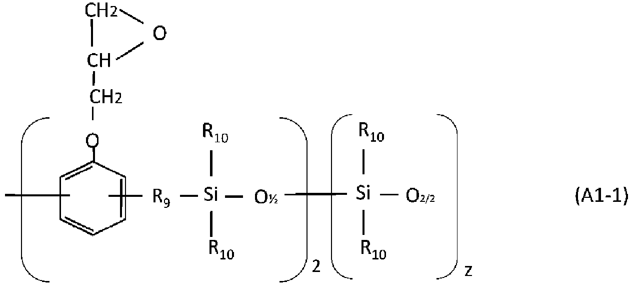

In Formula (A1-1), R₉ represents a divalent hydrocarbon group having 2 to 10 carbon atoms. R₁₀'s each independently represent any of a hydrogen atom, a monovalent hydrocarbon group or aromatic group having 1 to 30 carbon atoms, a hydroxyl group, and an alkoxyl group having 1 to 30 carbon atoms. z is an integer of 0 to 10.

Among these, R₉ is preferably a divalent hydrocarbon group having 2 to 5 carbon atoms, more preferably a divalent hydrocarbon group having 2 to 4 carbon atoms, and still more preferably a propenyl group. R₁₀'s are each independently preferably a monovalent hydrocarbon group having 1 to 20 carbon atoms and is more preferably a monovalent hydrocarbon group having 1 to 10 carbon atoms. In addition, it is preferably an alkyl group, more preferably an alkyl group having 1 to 5 carbon atoms, and still more preferably a methyl group.

The epoxy resin (A1) can be produced by epoxidizing the above-described phenol resin (P1) by a publicly known method.

### [Epoxy compound (A2)]

The epoxy compound (A2) is a di- or higher functional epoxy compound (A2) having a structure represented by Formula (A2) below.

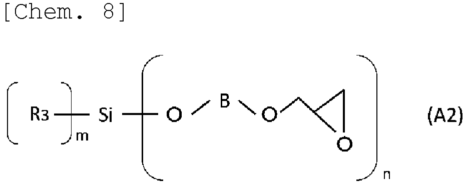

In Formula (A2), m and n are integers, and m + n is 4.

R₃'s are independently hydrogen, alkyl, alkenyl, alkynyl, cycloalkyl, cycloalkenyl, cycloalkynyl, aryl, heterocyclic, heterocycloalkyl, cycloalkenyl, heteroaryl, alkoxyaryl, or alkoxyalkyl.

B's are independently an arylene, an arylene ether, an alkylene-arylene, an alkylene-arylene alkylene, an alkenylene-arylene, an alkenylene-arylene alkenylene, an alkylene-arylene-alkylene, an alkynylene-arylene, an alkynylene-arylene-alkynylene, a heteroarylene, an alkylene-heteroarylene, an alkylene-heteroarylene-alkylene, an alkenylene-heteroarylene, an alkenylene-heteroarylene-alkylene, an alkylene-heteroarylene-alkylene, an alkynylene heteroarylene, an alkynylene-heteroarylene-alkynylene, an alkylene, an alkylene-hetero-alkylene, an alkenylene, an alkenylene-hetero-alkylene, an alkylene-hetero-alkylene, an alkynylene, a cycloalkylene, an alkylene-cycloalkylene, an alkylene-cycloalkylene alkylene, an alkenylene-cycloalkylene, an alkenylene cycloalkylene-alkenylene, an alkylene-cycloalkylene alkenylene, an alkynylene-cycloalkylene, an alkynylene cycloalkylene-alkynylene, a heterocycloalkylene, an alkylene heterocycloalkylene, an alkylene-heterocycloalkylene-alkylene, an alkenylene-heterocycloalkylene, an alkenylene heterocycloalkylene-alkenylene, an alkylene heterocycloalkylene-alkenylene, an alkynylene heterocycloalkylene, an alkynylene-heterocycloalkylene-alkynylene, a cycloalkenylene, an alkylene-cycloalkenylene, an alkylene-cycloalkenylene-alkylene, an alkenylene-cycloalkenylene, an alkenylene-cycloalkenylene-alkenylene, an alkylene-cycloalkenylene-alkenylene, an alkynylene-cycloalkenylene, an alkynylene-cycloalkenylene-alkynylene, a heterocycloalkenylene, an alkylene-heterocycloalkenylene, an alkylene-heterocycloalkenylene-alkylene, an alkenylene-heterocycloalkenylene, an alkenylene-heterocycloalkenylene-alkenylene, an alkylene-heterocycloalkenylene-alkenylene, an alkynylene heterocycloalkenylene, an alkynylene-heterocycloalkenylene, or an alkynylene.

Specific examples of the above-described di- or higher functional epoxy compound (A2) include compounds represented by Formulae (A2-1) to (A2-19), respectively.

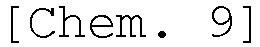

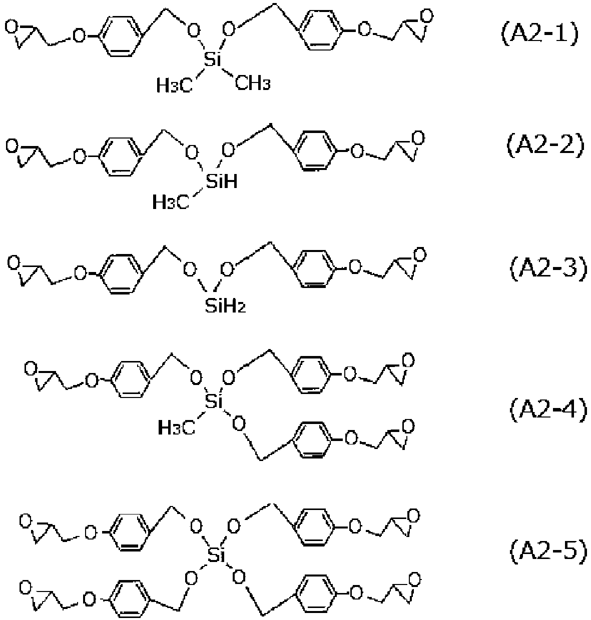

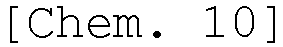

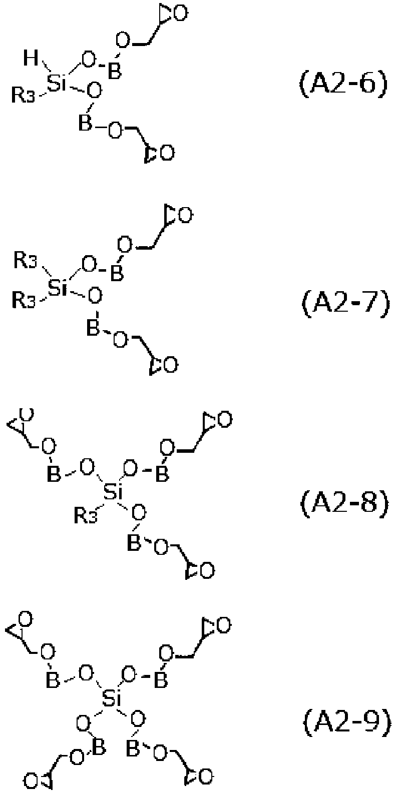

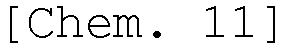

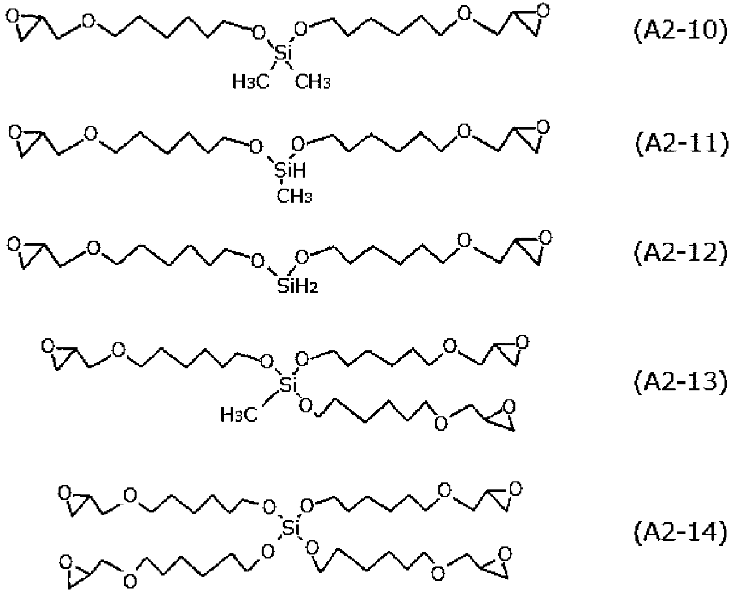

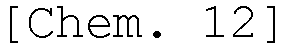

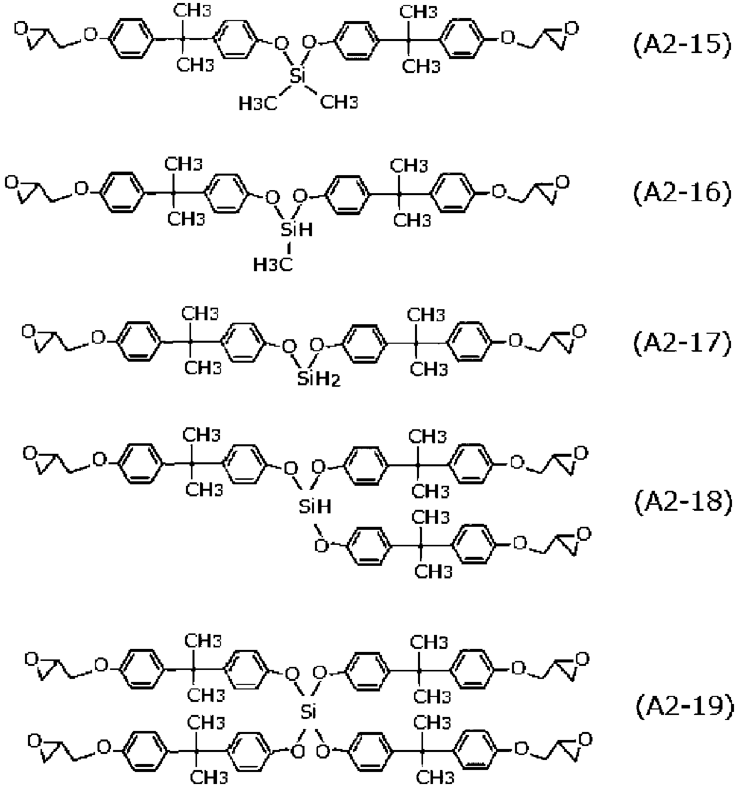

The epoxy compound (A2) can be obtained, for example, as follows.

First, a step of partially epoxidizing a polyhydric alcohol having one or a plurality of hydroxy groups with epihalohydrin in the presence of a base to obtain a partially epoxidized alcohol, and a step of reacting the partially epoxidized alcohol with a compound having a structure represented by each of Formulae (4-1) to (4-3) in the presence of an acidic catalyst are provided. As a result, a mixture containing the epoxy compound (A2) having an -Si-O- structure can be obtained.

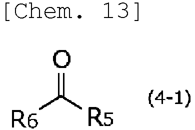

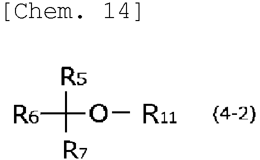

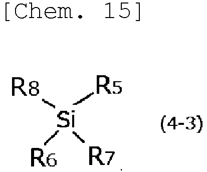

(In the formulae, R₅ to R₈ are each independently hydrogen, alkyl, alkenyl, alkynyl, methylene, cycloalkyl, cycloalkenyl, cycloalkynyl, aryl, heterocyclic, heterocycloalkyl, cycloalkenyl, heteroaryl, alkoxy, alkoxyaryl, alkoxyalkyl, or aryloxy, and R₁₁ is hydrogen, alkyl, aryl, aralkyl, alkenyl, or alkynyl.)

### [Epoxy compound (A3)]

The epoxy compound (A3) has a structure represented by Formula (A3) below.

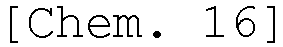

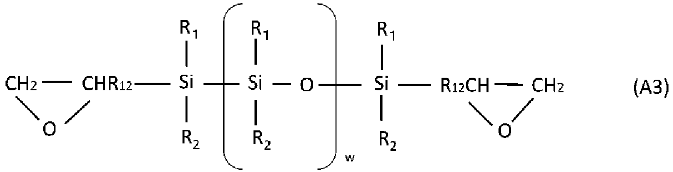

In Formula (A3), R₁ and R₂ each independently represent any of a hydrogen atom, a hydrocarbon group or aromatic group having 1 to 30 carbon atoms, a hydroxyl group, and an alkoxyl group having 1 to 30 carbon atoms.

R₁₂'s each independently represent any of a hydrogen atom or a hydrocarbon group having 1 to 30 carbon atoms.

w is an integer of 1 to 50.

As the epoxy compound (A3), a commercially available product can be used, and examples thereof include Dual-end Epoxy-modified Silicones "X-22-163", "X-22-163A", "X-22-163B", "X-22-163C", and "KF-105" (all of which are manufactured by Shin-Etsu Chemical Co., Ltd.).

In addition, specific examples of the above-described epoxy compound (A3) include a compound represented by Formula (A3-1) below.

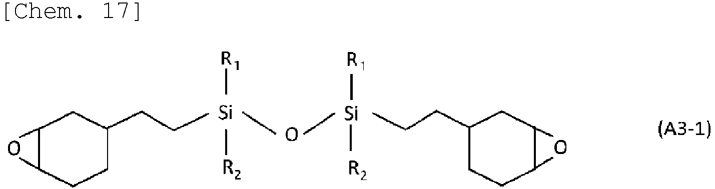

In Formula (A3-1), R₁ and R₂ each independently represent any of a hydrogen atom, a hydrocarbon group or aromatic group having 1 to 30 carbon atoms, a hydroxyl group, and an alkoxyl group having 1 to 30 carbon atoms.

Among these, R₁ and R₂ are preferably an alkyl group having 1 to 30 carbon atoms, more preferably an alkyl group having 1 to 3 carbon atoms, and still more preferably a methyl group.

As the epoxy compound represented by Formula (A3-1), a commercially available product can be used, and examples thereof include an alicyclic epoxy group-containing linear siloxane difunctional oligomer "X-40-2669" (manufactured by Shin-Etsu Chemical Co., Ltd.).

Hereinafter, a description will be made regarding the physical properties of the epoxy resin (A) having an -Si-O-structure according to the present embodiment will be described.

The weight average molecular weight (Mw) of the epoxy resin (A) having an -Si-O- structure according to the present embodiment is not particularly limited; however, it is preferably 500 to 10,000, more preferably 1,000 to 7,000, and still more preferably 2,000 to 6,000.

The number average molecular weight (Mn) of the epoxy resin (A) having an -Si-O- structure according to the present embodiment is not particularly limited; however, it is preferably 100 to 5,000, more preferably 300 to 3,000, and still more preferably 600 to 1,000.

In addition, the viscosity of the epoxy resin (A) having an -Si-O- structure according to the present embodiment is preferably in a range of 1 to 40,000 mPa·s.

In addition, the epoxy resin (A) having an -Si-O- structure according to the present embodiment preferably has an epoxy equivalent weight (EEW) in a range of 100 to 600 g/milliequivalents. It is noted that the epoxy equivalent weight means the mass (gram) of the resin containing 1 equivalent of epoxy.

In the third embodiment, it is suitable to use a publicly known phenol-based curing agent as the resin composition.

In addition, the phenol-based curing agent as a curing agent and the epoxy resin (A) having an -Si-O- structure are adjusted so that an equivalent ratio (EP)/(OH) of the number of epoxy groups (EP) in the total thermosetting resin to the number of phenolic hydroxyl groups (OH) in the total phenol resin is preferably 0.8 or more and 1.6 or less, more preferably 0.9 or more and 1.3 or less, and still more preferably 1.0 or more and 1.2 or less. In a case where the equivalent ratio is within the above-described range, the curing characteristics of the obtainable resin composition according to the present embodiment can be made favorable.

Other components contained in the resin composition according to the third embodiment will be described later.

### <Fourth embodiment>

In the fourth embodiment, a description will be made regarding a resin composition that contains, as a thermosetting resin, an organopolysiloxane (silicone resin) (C1) having two or more alkenyl groups bonded to a silicon atom in one molecule and that contains, as a curing agent (crosslinking agent), an organohydrogen polysiloxane (C2) having two or more hydrogen atoms bonded to a silicon atom in one molecule.

### (Organopolysiloxane (C1))

The organopolysiloxane (silicone resin) (C1) having two or more alkenyl groups bonded to a silicon atom in one molecule is preferably a linear organopolysiloxane, and it is a linear organopolysiloxane that preferably has, in one molecule, 2 to 8 alkenyl groups bonded to a silicon atom. Specific examples thereof include a compound having a structure represented by Formula (C1-1).

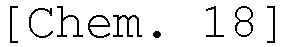

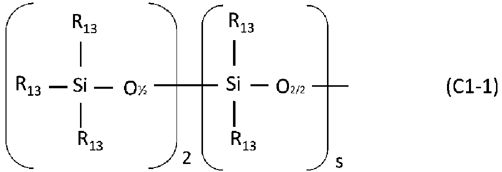

In Formula (C1-1), R₁₃'s are alkyl groups having 1 to 10 carbon atoms, aryl groups having 6 to 12 carbon atoms, or alkenyl groups having 2 to 10 carbon atoms, which are substituted or unsubstituted and which are the same or different from each other.

Specific examples of R₁₃ include groups in which an alkyl group such as a methyl, ethyl, propyl, butyl, pentyl, hexyl, or cyclohexyl group, or a part or all of hydrogen atoms bonded to carbon atoms of these alkyl groups are substituted with a halogen atom such as a chlorine atom, a fluorine atom, or a bromine atom, where the groups are for example, a fluorinesubstituted alkyl group such as a trifluoromethyl group or a 3,3,3-trifluoropropyl group, an alkenyl group such as a vinyl, allyl, butenyl, pentenyl, hexenyl, or cyclohexenyl group, and aryl groups such as a phenyl group.

Among these, an alkyl group having 1 to 6 carbon atoms, an aryl group having 6 to 8 carbon atoms, or an alkenyl group having 2 to 6 carbon atoms is preferable.

s is an integer of 5 to 50,000, and preferably an integer of 10 to 20,000.

Regarding the alkenyl group in the organopolysiloxane (C1), the organopolysiloxane (C1) may have the alkenyl group either at a terminal of the molecular chain or in the side chain; however, it preferably has the alkenyl group only at the terminal.

In addition, examples of the specific structure of the vinyl group-containing linear organopolysiloxane (C1-2) among the organopolysiloxanes (C1) include a compound represented by Formula (C1-2).

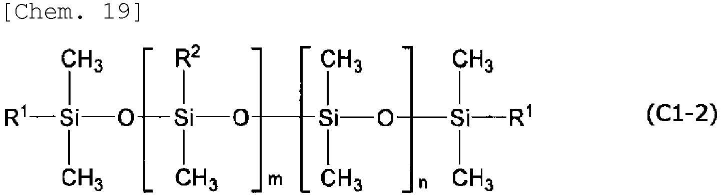

In Formula (C1-2), R¹ and R² are each independently a methyl group or a vinyl group, and at least one of R¹ or R² is a vinyl group.

The vinyl group-containing linear organopolysiloxane (C1-2) may contain a first vinyl group-containing linear organopolysiloxane (C1-2') which contains two or more vinyl groups in a molecule and in which the content thereof is 0.4% by mole or less. The amount of the vinyl group in the first vinyl group-containing linear organopolysiloxane (C1-2') may be 0.1% by mole or less.

In addition, the vinyl group-containing linear organopolysiloxane (C1-2) may include the first vinyl group-containing linear organopolysiloxane (C1-2') and a second vinyl group-containing linear organopolysiloxane (C1-2") in which the content of the vinyl group is in a range of 0.5% to 15% by mole.

By using a combination of the first vinyl group-containing linear organopolysiloxane (C1-2') and the second vinyl group-containing linear organopolysiloxane (C1-2") in which the content of the vinyl group is high, as raw rubber which is a raw material of silicone rubber, the vinyl groups can be unevenly distributed, and the sparseness and denseness in terms of the crosslinking density can be more effectively formed in the crosslinked network of the silicone rubber. As a result, the tearing strength of the release film is more effectively increased, and the dimensional stability and the transferability are easily controlled.

Specifically, as the vinyl group-containing linear organopolysiloxane (C1-2), for example, it is preferable to use the first vinyl group-containing linear organopolysiloxane (C1-2') in which, in Formula (C1-2), two or more of a unit in which R¹ represents a vinyl group and/or a unit in which R² represents a vinyl group are included in a molecule and the content of the units is 0.4% by mole or less, and the second vinyl group-containing linear organopolysiloxane (C1-2") in which the unit in which R¹ represents a vinyl group and/or the unit in which R² represents a vinyl group are included and the content of the units is 0.5% to 15% by mole.

The first vinyl group-containing linear organopolysiloxane (C1-2') preferably has a vinyl group content of 0.01% to 0.2% by mole. In addition, the second vinyl group-containing linear organopolysiloxane (C1-2") preferably has a vinyl group content of 0.8% to 12% by mole.

In a case where the first vinyl group-containing linear organopolysiloxane (C1-2') and the second vinyl group-containing linear organopolysiloxane (C1-2") are blended together, the ratio between (C1-2') and (C1-2") is not particularly limited. For example, the weight ratio (C1-2'):(C1-2") is preferably 50:50 to 95:5, and more preferably 80:20 to 90:10.

As each of the first and second vinyl group-containing linear organopolysiloxanes (C1-2') and (C1-2"), only one compound may be used, or two or more compounds may be used in combination.

In addition, the organopolysiloxane (C1) may contain a vinyl group-containing branched organopolysiloxane having a branched structure.

### (Organohydrogen polysiloxane (C2))

Examples of the organohydrogen polysiloxane (C2) having two or more hydrogen atoms bonded to a silicon atom in one molecule include an organohydrogen polysiloxane having a structure represented by Formula (C2).

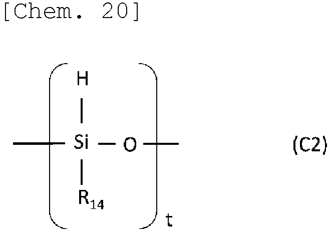

In Formula (C2), R₁₄'s are each independently an alkyl group such as a methyl group, an ethyl group, a propyl group, or a butyl group, a cycloalkyl group such as a cyclohexyl group, an aryl group such as a phenyl group or a tolyl group, or is a group obtained by substituting a part or all of hydrogen atoms bonded to carbon atoms of these groups with a hydroxyl group, a cyano group, a halogen atom, or the like. It is preferably a monovalent hydrocarbon group having 1 to 10 carbon atoms, and more preferably an alkyl group or an aryl group. t is an integer of 2 or more, and it is preferably 2 to 50 and more preferably 3 to 30.

The blending amount of the organohydrogen polysiloxane (C2) is appropriately set according to the number of moles of the alkenyl group in the organopolysiloxane (C1) having two or more alkenyl groups in one molecule; however, it is preferable to carry out adjustment so that the number of moles of the SiH group in the organohydrogen polysiloxane (C2) is in a range of 0.5 to 20 with respect to the alkenyl group in the silicone resin (C1) and more preferably in a range of 0.8 to 5.

The organohydrogen polysiloxane (C2) is classified into a linear organohydrogen polysiloxane (C2-1) having a linear structure and a branched organohydrogen polysiloxane (C2-2) having a branched structure, and it can include any one or both of these.

The linear organohydrogen polysiloxane (C2-1) is a polymer that has a linear structure and has a structure in which hydrogen is directly bonded to Si (≡Si-H), and that undergoes a hydrosilylation reaction with a vinyl group in the vinyl group-containing organopolysiloxane (C1-2) and a vinyl group of a component contained in a raw material of a release layer 1 and crosslinks these components.

The molecular weight of the linear organohydrogen polysiloxane (C2-1) is not particularly limited; however, the weight average molecular weight thereof is, for example, preferably 20,000 or less, and more preferably 1,000 or more and 10,000 or less.

The weight average molecular weight of the linear organohydrogen polysiloxane (C2-1) can be measured as a polystyrene-equivalent value by gel permeation chromatography (GPC) using chloroform as an elution solvent.

It is preferable that the linear organohydrogen polysiloxane (C2-1) contains no vinyl group in general. This makes it possible to reliably prevent a crosslinking reaction from progressing in the molecule of the linear organohydrogen polysiloxane (C2-1).

As the linear organohydrogen polysiloxane (C2-1), for example, a compound having a structure represented by Formula (C2-1) below is preferably used.

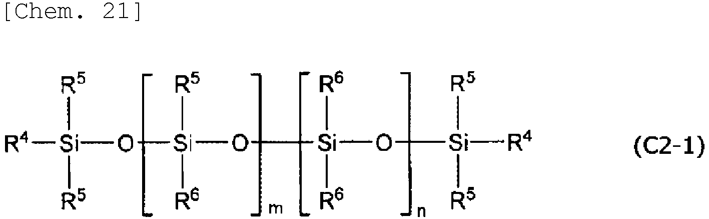

In Formula (C2-1), R⁴ represents a substituted or unsubstituted alkyl group, alkenyl group, or aryl group having 1 to 10 carbon atoms, a hydrocarbon group obtained by combining these, or a hydride group. Examples of the alkyl group having 1 to 10 carbon atoms include a methyl group, an ethyl group, and a propyl group. Among these, a methyl group is preferable. Examples of the alkenyl group having 1 to 10 carbon atoms include a vinyl group, an allyl group, and a butenyl group. Examples of the aryl group having 1 to 10 carbon atoms include a phenyl group.

R⁵ represents a substituted or unsubstituted alkyl group, alkenyl group, or aryl group having 1 to 10 carbon atoms, a hydrocarbon group obtained by combining these, or a hydride group. Examples of the alkyl group having 1 to 10 carbon atoms include a methyl group, an ethyl group, and a propyl group. Among these, a methyl group is preferable. Examples of the alkenyl group having 1 to 10 carbon atoms include a vinyl group, an allyl group, and a butenyl group. Examples of the aryl group having 1 to 10 carbon atoms include a phenyl group.

In Formula (C2-1), a plurality of R⁴'s are independent of each other and may be the same or different from each other. The same shall be applied to R⁵. Here, at least two or more among the plurality of R⁴'s and the plurality of R⁵'s represent hydride groups.

R⁶ represents a substituted or unsubstituted alkyl group or aryl group having 1 to 8 carbon atoms, or a hydrocarbon group obtained by combining these. Examples of the alkyl group having 1 to 8 carbon atoms include a methyl group, an ethyl group, and a propyl group. Among these, a methyl group is preferable. Examples of the aryl group having 1 to 8 carbon atoms include a phenyl group. A plurality of R⁶'s are independent of each other and may be the same or different from each other.

Examples of substituents of R⁴, R⁵, and R⁶ in Formula (C2-1) include a methyl group, a vinyl group, and the like. From the viewpoint of preventing an intramolecular crosslinking reaction, a methyl group is preferable.

m and n each independently represent the number of repeating units configuring the linear organohydrogen polysiloxane (C2-1) represented by Formula (C2-1), m represents an integer of 2 to 150, and n represents an integer of 2 to 150. It is preferable that m represents an integer of 2 to 100 and n represents an integer of 2 to 100.

As the linear organohydrogen polysiloxane (C2-1), only one compound may be used alone, or two or more compounds may be used in combination.

Due to having a branched structure, the branched organohydrogen polysiloxane (C2-2) is a component that forms a region having a high crosslinking density, thereby largely contributing to the formation of a structure having the sparseness and denseness in terms of the crosslinking density in the silicone rubber system. In addition, similar to the linear organohydrogen polysiloxane (C2-1), it is a polymer that has a structure in which hydrogen is directly bonded to Si (≡Si-H), and that undergoes a hydrosilylation reaction with a vinyl group in the vinyl group-containing organopolysiloxane (C1-2) and a vinyl group of a component contained in a raw material of a release layer 1 and crosslinks these components.

In addition, the specific gravity of the branched organohydrogen polysiloxane (C2-2) is in a range of 0.9 to 0.95.

It is preferable that the branched organohydrogen polysiloxane (C2-2) contains no vinyl group in general. This makes it possible to reliably prevent a crosslinking reaction from progressing in the molecule of the branched organohydrogen polysiloxane (C2-2).

The branched organohydrogen polysiloxane (C2-2) is preferably represented by an average compositional formula (c) below.

Average compositional formula (c)

(Ha(R⁷)3-aSiO_{1/2})m(SiO_{4/2})n

(In Formula (c), R⁷ represents a monovalent organic group, a represents an integer of 1 to 3, m represents the number of Ha(R⁷)₃-aSiO_{1/2} units, and n represents the number of SiO_{4/2} units.)

In Formula (c), R⁷ represents a monovalent organic group, and preferably represents a substituted or unsubstituted alkyl group or aryl group having 1 to 10 carbon atoms, or a hydrocarbon group obtained by combining these. Examples of the alkyl group having 1 to 10 carbon atoms include a methyl group, an ethyl group, and a propyl group. Among these, a methyl group is preferable. Examples of the aryl group having 1 to 10 carbon atoms include a phenyl group.

In Formula (c), a represents the number of hydride groups (hydrogen atoms directly bonded to Si) which is an integer of 1 to 3. a is preferably 1.

In addition, in Formula (c), m represents the number of Ha(R⁷)₃-aSiO_{1/2} units, and n represents the number of SiO_{4/2} units.

The branched organohydrogen polysiloxane (C2-2) has a branched structure. The linear organohydrogen polysiloxane (C2-1) and the branched organohydrogen polysiloxane (C2-2) are different in that their structures are linear or branched. When the number of Si is 1, the number of alkyl groups R (R/Si) bonded to Si is in a range of 1.8 to 2.1 for the linear organohydrogen polysiloxane (C2-1), and it is 0.8 to 1.7 for the branched organohydrogen polysiloxane (C2-2).

The residue amount of the branched organohydrogen polysiloxane (C2-2) is 5% or more due to having a branched structure in a case of being heated, for example, to 1,000°C at a temperature rising rate of 10 °C/min in a nitrogen atmosphere. On the other hand, due to having a linear structure, the linear organohydrogen polysiloxane (C2-1) substantially does not leave residues after being heated under the above conditions.

Specific examples of the branched organohydrogen polysiloxane (C2-2) include compounds having a structure represented by Formula (C2-2) below.

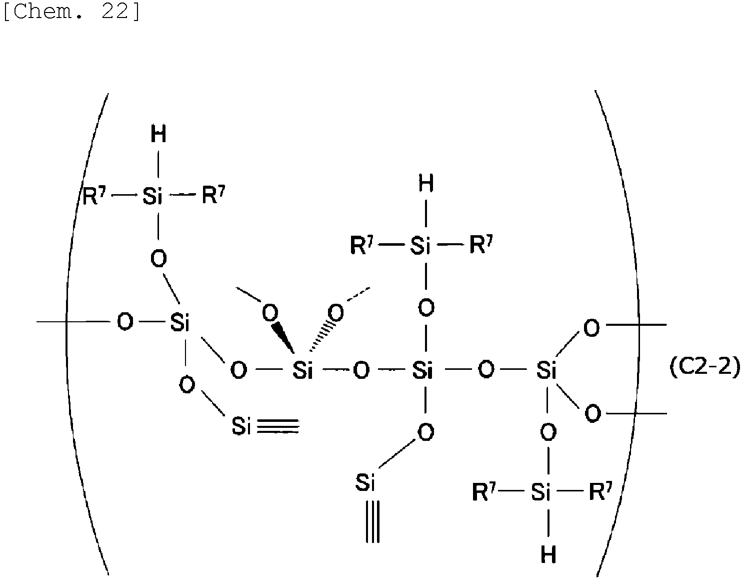

In Formula (C2-2), R⁷ represents a substituted or unsubstituted alkyl group or aryl group having 1 to 8 carbon atoms, a hydrocarbon group obtained by combining these, or a hydrogen atom. Examples of the alkyl group having 1 to 8 carbon atoms include a methyl group, an ethyl group, and a propyl group. Among these, a methyl group is preferable. Examples of the aryl group having 1 to 8 carbon atoms include a phenyl group. Examples of the substituent of R⁷ include a methyl group.

In Formula (C2-2), a plurality of R⁷'s are independent of each other and may be the same or different from each other.

In Formula (C2-2), "-O-Si≡" means that Si has a branched structure that expands three-dimensionally.

As the branched organohydrogen polysiloxane (C2-2), only one compound may be used alone, or two or more compounds may be used in combination.

In each of the linear organohydrogen polysiloxane (C2-1) and the branched organohydrogen polysiloxane (C2-2), the amount of hydrogen atoms (hydride groups) directly bonded to Si is not particularly limited.

Here, in the release layer 1, the total amount of hydride groups in the linear organohydrogen polysiloxane (C2-1) and the branched organohydrogen polysiloxane (C2-2) is preferably 0.5 to 5 mol and more preferably 1 to 3.5 mol with respect to 1 mol of vinyl groups in the vinyl group-containing linear organopolysiloxane (C1-1). In a case where the total amount of hydride groups is in the above range, a crosslinked network can be reliably formed among the linear organohydrogen polysiloxane (C2-1) and the branched organohydrogen polysiloxane (C2-2), and the vinyl group-containing linear organopolysiloxane (C1-1).

### (Catalyst and curing accelerator)

In the fourth embodiment, it is preferable that the resin composition further contains a catalyst. This makes it possible to accelerate the curing between the organopolysiloxane (C1) and the organohydrogen polysiloxane (C2).

Examples of the catalyst include a platinum-based catalyst, a rhodium-based catalyst, and a palladium-based catalyst, among which platinum is preferable.

Specific examples of the platinum-based catalyst include a platinum fine powder, chloroplatinic acid, an alcohol solution of chloroplatinic acid, a platinum-alkenyl siloxane complex, a platinum-olefin complex, a platinum-carbonyl complex, and a catalyst obtained by dispersing or encapsulating these platinum-based catalysts in a thermoplastic resin.

An adding amount of the catalyst is preferably 0.01% by mass to 5% by mass, more preferably 0.02% by mass to 2% by mass, and still more preferably 0.05% by mass to 1% by mass with respect to the total amount of the resin composition.

Other components contained in the resin composition according to the fourth embodiment will be described later.

As described above, the examples of the embodiments of the resin composition according to the present invention have been described. However, the resin composition according to the embodiment of the present invention is not limited thereto.

In addition, the resin composition according to each of the above-described embodiments may further contain a publicly known thermosetting resin and a publicly known curing agent, in addition to the above-described thermosetting component, and may further contain other components depending on the use application.

Hereinafter, a description will be made regarding other components which may be contained in the resin composition according to the embodiment of the present invention.

### [Thermosetting resin]

Examples of the thermosetting resin according to the present embodiment include one or two or more resins selected from a phenol resin, an epoxy resin, a phenoxy resin, a polyimide resin, a benzoxazine resin, an unsaturated polyester resin, a melamine resin, a silicone resin, a cyanate resin, a maleimide resin, a cyanate resin, and an acrylic resin. As these thermosetting resins, a monomer, an oligomer, and a polymer, which have two or more reactive functional groups in one molecule, can be used in general, and the molecular weight or molecular structure thereof is not particularly limited.

As the epoxy resin, a monomer, an oligomer, or a polymer, which has two or more epoxy groups in one molecule, can be used in general, and the molecular weight or molecular structure thereof is not particularly limited.

Specific examples of the epoxy resin include one or two or more selected from a novolac-type epoxy resin such as a phenol novolac-type epoxy resin or a cresol novolac-type epoxy resin; a bisphenol-type epoxy resin such as a bisphenol A-type epoxy resin or a bisphenol F-type epoxy resin; an aromatic glycidylamine-type epoxy resin such as N,N-diglycidylaniline, N,N-diglycidyltoluidine, a diaminodiphenylmethane-type glycidylamine, or an aminophenol-type glycidylamine; a hydroquinone-type epoxy resin; a biphenyl-type epoxy resin; a stilbene-type epoxy resin; a triphenolmethane-type epoxy resin; a triphenolpropane-type epoxy resin; an alkyl-modified triphenolmethane-type epoxy resin; a triazine nucleus-containing epoxy resin; a dicyclopentadiene-modified phenol-type epoxy resin; a naphthol-type epoxy resin; a naphthalene-type epoxy resin; a naphthylene ether-type epoxy resin; and an aralkyl-type epoxy resin or the like such as a phenol aralkyl-type epoxy resin having a phenylene and/or biphenylene skeleton or a naphthol aralkyl-type epoxy resin having a phenylene and/or biphenylene skeleton, or an aliphatic epoxy resins such as an alicyclic epoxy such as vinylcyclohexene dioxide, dicyclopentadiene oxide, or an alicyclic diepoxy adipate.

The content of the thermosetting resin is preferably 1% by mass or more and 50% by mass or less, more preferably 2% by mass or more and 30% by mass or less, and still more preferably 5% by mass or more and 20% by mass or less with respect to the total amount of the resin composition.

In a case where the content of the thermosetting resin is set to be equal to or larger than the above-described lower limit value, the fluidity of the resin composition and the moldability can be more effectively improved. In addition, in a case where the content of the thermosetting resin is set to be equal to or smaller than the above-described upper limit value, the curability can be improved, and a favorable cured product can be obtained.

### [Curing agent]

The curing agent according to the present embodiment is selected according to the kind of the thermosetting resin and is not particularly limited as long as it reacts with the thermosetting resin. Specific examples of the curing agent include a polyaddition-type curing agent, a catalyst-type curing agent, and a condensation-type curing agent.

Specific examples of the curing agent include a phenol-based curing agent, amines, a polyoxystyrene such as polyparaoxystyrene, an acid anhydride including an alicyclic acid anhydride such as hexahydrophthalic anhydride (HHPA) or methyltetrahydrophthalic anhydride (MTHPA), an aromatic acid anhydride such as trimellitic anhydride (TMA), pyromellitic anhydride (PMDA), or benzophenonetetracarboxylic acid (BTDA), and the like, a polymercaptan compound such as a polysulfide, a thioester, or thioether, an isocyanate compound such as an isocyanate prepolymer or a blocked isocyanate, and organic acids such as a carboxylic acid-containing polyester resin.

Specific examples of the phenol-based curing agent include one or more selected from a novolac-type phenol resin such as a phenol novolac resin, a cresol novolac resin, a naphthol novolac resin, an amino triazine novolac resin, a novolac resin, or a trisphenylmethane-type phenol novolac resin; a modified phenol resin such as a terpene-modified phenol resin or a dicyclopentadiene-modified phenol resin; an aralkyl-type resin such as a phenol aralkyl resin having a phenylene skeleton and/or a biphenylene skeleton, or a naphthol aralkyl resin having a phenylene skeleton and/or a biphenylene skeleton; a bisphenol compound such as bisphenol A or bisphenol **F; a** resorcinol-type phenol resin; and the like. In addition, from the viewpoint of curability, it is suitable that the hydroxyl group equivalent of the phenol resin-based curing agent is set to, for example, 90 g/eq or more and 250 g/eq or less.

Specific examples of the above-described amines include one or two or more selected from polyamine compounds including aliphatic polyamines such as diethylenetriamine (DETA), triethylenetetramine (TETA), and methaxylenediamine (MXDA), and aromatic polyamines such as diaminodiphenylmethane (DDM), **m-**phenylenediamine (MPDA), and diaminodiphenylsulfone (DDS), as well as dicyandiamide (DICY), an organic acid dihydrazide, and the like; acid anhydrides including an alicyclic acid anhydride such as hexahydrophthalic anhydride (HHPA) or methyltetrahydrophthalic anhydride (MTHPA), an aromatic acid anhydride such as trimellitic anhydride (TMA), pyromellitic anhydride (PMDA), or benzophenonetetracarboxylic acid (BTDA), and the like; and the like.

The content of the curing agent is preferably 5 to 50 parts by mass and more preferably 10 to 30 parts by mass with respect to 100 parts by mass of the thermosetting resin.

In addition, the content of the thermosetting resin and the curing agent is appropriately set according to the thermosetting resin and the curing agent. For example, the phenol-based curing agent as a curing agent and the epoxy resin as a thermosetting resin are adjusted so that an equivalent ratio (EP)/(OH) of the number of epoxy groups (EP) in the total thermosetting resin to the number of phenolic hydroxyl groups (OH) in the total phenol resin is preferably 0.8 or more and 1.6 or less, more preferably 0.9 or more and 1.3 or less, and still more preferably 1.0 or more and 1.2 or less. In a case where the equivalent ratio is within the above-described range, the curing characteristics of the obtainable resin composition according to the present embodiment can be made favorable.

The resin composition according to the present embodiment may further contain the following components.

### [Inorganic filler]

The resin composition according to the present embodiment may contain an inorganic filler.

The inorganic filler is used for increasing mechanical strength or imparting heat resistance, flame retardancy, or the like depending on the use application of the cured product or the structural body.

Specific examples of the inorganic filler include silicates such as talc, baked clay, unbaked clay, mica, and glass; oxides such as titanium oxide, alumina, boehmite, and silica; carbonates such as calcium carbonate, magnesium carbonate, and hydrotalcite; hydroxides such as aluminum hydroxide, magnesium hydroxide, and calcium hydroxide; sulfates or bisulfates such as barium sulfate, calcium sulfate, and calcium bisulfate; borates such as zinc borate, barium metaborate, aluminum borate, calcium borate, and sodium borate; nitrides such as aluminum nitride, boron nitride, silicon nitride, and carbon nitride; and titanates such as strontium titanate and barium titanate. One kind of these may be used alone, or two or more kinds thereof may be used in combination.

An average particle diameter D50 of the inorganic filler is preferably 0.01 µm or more and 75 µm or less, and more preferably 0.05 µm or more and 50 µm or less. In a case where the average particle diameter of the inorganic filler is set within the above-described range, the filling property is improved. The average particle diameter D50 can be a volume-based (accumulation: 50%) average particle diameter that is measured by a commercially available laser-type particle size distribution analyzer.

The content of the inorganic filler is appropriately set according to the use application; however, it is preferably 10% by mass to 98% by mass, more preferably 20% by mass to 95% by mass, and still more preferably 40% by mass to 95% by mass with respect to the total amount of the resin composition.

In a case where the content of the inorganic filler is set to be equal to or larger than the above-described lower limit value, the storage stability and the curability of the cured product can be improved. In addition, in a case where the content of the inorganic filler is set to be equal to or smaller than the above-described upper limit value, the favorable fluidity of the resin composition can be obtained, and the moldability can be effectively improved.

### [Coupling agent]

In a case where the resin composition according to the present embodiment contains an inorganic filler, the resin composition may contain a coupling agent. As a result, it is possible to suppress the aggregation of the inorganic filler and obtain favorable fluidity.

Examples of the coupling agent include various silane-based compounds such as epoxysilane, mercaptosilane, aminosilane, an alkyl silane, ureide silane, and vinylsilane, and publicly known coupling agents such as a titanium-based compound, an aluminum chelate, and an aluminum-zirconium-based compound.

Specific examples thereof include silane-based coupling agents such as vinyltrichlorosilane, vinyltrimethoxysilane, vinyltriethoxysilane, vinyltris(β-methoxyethoxy)silane, γ-methacryloxypropyltrimethoxysilane, β-(3,4-epoxycyclohexyl)ethyltrimethoxysilane, γ-glycidoxypropyltrimethoxysilane, γ-glycidoxypropyltriethoxysilane, γ-glycidoxypropyl methyldimethoxysilane, γ-methacryloxypropylmethyldiethoxysilane, γ-methacryloxypropyltriethoxysilane, vinyltriacetoxysilane, γ-mercaptopropyltrimethoxysilane, γ-aminopropyltriethoxysilane, γ-anilinopropyltrimethoxysilane, γ-anilinopropylmethyldimethoxysilane, γ-[bis(β-hydroxyethyl)]aminopropyltriethoxysilane, N-β-(aminoethyl)-γ-aminopropyltrimethoxysilane, N-β-(aminoethyl)-γ-aminopropyltriethoxysilane, N-β-(aminoethyl)-γ-aminopropylmethyldimethoxysilane, N-phenyl-γ-aminopropyltrimethoxysilane, γ-(β-aminoethyl)aminopropyldimethoxymethylsilane, N-(trimethoxysilylpropyl)ethylenediamine, N-(dimethoxymethylsilylisopropyl)ethylenediamine, methyltrimethoxysilane, dimethyldimethoxysilane, methyltriethoxysilane, N-β-(N-vinylbenzylaminoethyl)-γ-Aminopropyltrimethoxysilane, γ-chloropropyltrimethoxysilane, hexamethyldisilane, vinyltrimethoxysilane, γ-mercaptopropylmethyldimethoxysilane, 3-isocyanatepropyltriethoxysilane, 3-acryloxypropyltrimethoxysilane, a hydrolysate of 3-triethoxysilyl-N-(1,3-dimethyl-butylidene)propylamine); and titanate-based coupling agents such as isopropyltriisostearoyl titanate, isopropyltris(dioctylpyrophosphate)titanate, isopropyltri(N-aminoethyl-aminoethyl)titanate, tetraoctylbis(ditridecylphosphite)titanate, tetra(2,2-diallyloxymethyl-1-butyl)bis(ditridecyl)phosphite titanate, bis(dioctylpyrophosphate)oxyacetate titanate, bis(dioctylpyrophosphate)ethylene titanate, isopropyltrioctanoyl titanate, isopropyldimethacrylic isostearoyl titanate, isopropyltridodecylbenzenesulfonyl titanate, isopropylisostearoyl diacrylic titanate, isopropyltri(dioctyl phosphate)titanate, isopropyl tricumylphenyl titanate, and tetraisopropylbis(dioctyl phosphite) titanate. One kind of these may be used alone, or two or more kinds thereof may be used in combination.

The content of the coupling agent is not particularly limited; however, it is preferably 0.05% by mass or more and 3% by mass or less, and more preferably 0.1% by mass or more and 2% by mass or less with respect to the entirety of the resin composition. In a case where the content of the coupling agent is set to be equal to or larger than the above-described lower limit value, the dispersibility of the inorganic filler in the resin composition can be made favorable. In addition, in a case where the content of the coupling agent is set to be equal to or smaller than the above-described upper limit value, the fluidity of the resin composition can be made favorable, and the improvement of the moldability can be achieved.

### [Curing accelerator]

The resin composition according to the present embodiment may contain a curing accelerator.

The curing accelerator typically accelerates a reaction between a thermosetting resin and a curing agent.

Specific examples of the curing accelerator include phosphorus atom-containing compounds such as an organic phosphine, a tetra-substituted phosphonium compound, a phosphobetaine compound, an adduct of a phosphine compound and a quinone compound, and an adduct of a phosphonium compound and a silane compound; amidine-based compounds such as 1,8-diazabicyclo(5,4,0)undecene-7 and imidazole; tertiary amines such as benzyldimethylamine; nitrogen atom-containing compounds such as an amidinium salt and an ammonium salts; and phenol compounds such as phenol, bisphenol A, nonylphenol, and 2,3-dihydroxynaphthalene.

In addition, examples of the above-described organic phosphine include triphenylphosphine, tri-p-tolylphosphine, tetraphenylphosphonium tetraphenylborate, triphenylphosphine triphenylborane, and 1,2-bis-(diphenylphosphino)ethane. One kind of these may be used alone, or two or more kinds thereof may be used in combination.

The content of the curing accelerator is appropriately set according to the use application; however, it is preferably 0.1% by mass to 5% by mass and more preferably 0.2% by mass to 3% by mass with respect to the total amount of the resin composition.

In a case where the content of the curing accelerator is set to be equal to or larger than the above-described lower limit value, the resin composition is easily cured appropriately. On the other hand, in a case where the content of the curing accelerator is set to be equal to or smaller than the above-described upper limit value, the molten state can be maintained for a longer time, and the low-viscosity state can be maintained for a longer time.

### [Hydroxyl group-containing cyclic compound]

In a case of containing a curing accelerator, the resin composition according to the present embodiment may contain a compound in which two or more adjacent carbon atoms constituting an aromatic ring are each bonded to a hydroxyl group (hereinafter, also referred to as a "hydroxyl group-containing cyclic compound"). As a result, even in a case where a phosphorus atom-containing curing accelerator having no latency is used as the curing accelerator, a reaction during the melt-kneading of the resin composition can be suppressed, and thus a stable resin composition can be obtained. In addition, the hydroxyl group-containing cyclic compound also has the effect of lowering the melt viscosity of the resin composition and improving the fluidity.

As the hydroxyl group-containing cyclic compound, a monocyclic compound represented by General Formula (5) or a polycyclic compound represented by General Formula (6) can be used. These compounds may have a substituent other than the hydroxyl group.

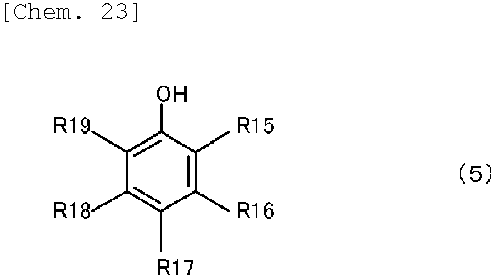

In General Formula (5), any one of R15 or R19 is a hydroxyl group, and the other is a hydrogen atom, a hydroxyl group, or a substituent other than a hydroxyl group. In addition, R16, R17, and R18 are a hydrogen atom, a hydroxyl group, or a substituent other than a hydroxyl group.

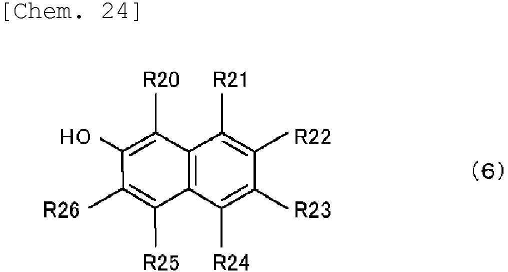

In General Formula (6), any one of R20 or R26 is a hydroxyl group, and the other is a hydrogen atom, a hydroxyl group, or a substituent other than a hydroxyl group. In addition, R21, R22, R23, R24, and R25 are a hydrogen atom, a hydroxyl group, or a substituent other than a hydroxyl group.

Specific examples of the monocyclic compound represented by General Formula (5) include catechol, pyrogallol, gallic acid, a gallic acid ester, and a derivative thereof.

In addition, specific examples of the polycyclic compound represented by General Formula (6) include 1,2-dihydroxynaphthalene, 2,3-dihydroxynaphthalene, and a derivative thereof. Among these, a compound in which two adjacent carbon atoms constituting an aromatic ring are each bonded to a hydroxyl group is preferable from the ease of control of fluidity and curability. In addition, in a case where the volatilization in the kneading step is taken into consideration, it is more preferable that the mother nucleus is a compound having a naphthalene ring which has a low volatility and has high weighing stability. In this case, the hydroxyl group-containing cyclic compound can be, specifically, a compound having a naphthalene ring, for example, 1,2-dihydroxynaphthalene, 2,3-dihydroxynaphthalene, or a derivative thereof. One kind of these hydroxyl group-containing cyclic compounds may be used alone, or two or more kinds thereof may be used in combination.

The content of the hydroxyl group-containing cyclic compound is preferably 0.01% by mass or more, more preferably 0.03% by mass or more, and still more preferably 0.05% by mass or more with respect to the total value of 100% by mass of the resin composition. In a case where the content of the hydroxyl group-containing cyclic compound is within the above-described range, it is possible to obtain an effect of sufficiently reducing the viscosity and improving the fluidity of the resin composition. In addition, the content of the hydroxyl group-containing cyclic compound is preferably 2% by mass or less, more preferably 0.8% by mass or less, and still more preferably 0.5% by mass or less with respect to the total value of 100% by mass of the resin composition. In a case where the content of the hydroxyl group-containing cyclic compound is within the above-described range, there is less concern that the curability of the resin composition or physical properties of the cured product are deteriorated.

Further, the resin composition according to the present embodiment can further contain, for example, a coloring agent such as carbon black; a mold releasing agent such as natural wax, synthetic wax, a higher fatty acid or a metal salt thereof, paraffin, or oxidized polyethylene; a low stress agent such as silicone oil or silicone rubber; a flame retardant such as aluminum hydroxide; an ion-capturing agent such as a hydrous oxide of an element selected from hydrotalcites or magnesium, aluminum, bismuth, titanium, and zirconium; and various additives such as an adhesion imparting agent such as thiazoline, diazole, triazole, triazine, and pyrimidine, and an antioxidant.

Next, a description will be made regarding a production method for the resin composition according to the present embodiment.

The production method for the resin composition according to the present embodiment is not particularly limited; however, for example, a thermosetting component and each of optional components are mixed using a mixer or the like, and then the resultant mixture is kneaded by being melted and heated at a temperature of about 90°C to 120°C using a heating kneader, a thermal roll, an extruder, or the like. Next, the obtained kneaded product is cooled and pulverized to obtain a powdery or granular resin composition. As necessary, the resin composition may be subjected to tableting molding after the pulverization, or it may be formed into a sheet shape by, for example, vacuum lamination molding or compression molding after the pulverization.

In addition, for example, a thermosetting component and each of optional components may be dissolved, mixed, and stirred in a solvent using various mixing machines, such as an ultrasonic dispersion-type mixer, a high-pressure impact dispersion-type mixer, a high-speed rotary dispersion-type mixer, a bead mill-type mixer, a high-speed shear dispersion-type mixer, and rotating and revolution dispersion-type mixer, whereby a varnish-like resin composition is prepared.

Specific examples of the solvent include acetone, methyl ethyl ketone, methyl isobutyl ketone, toluene, ethyl acetate, heptane, cyclohexane, cyclohexanone, tetrahydrofuran, dimethylformamide, dimethylacetamide, dimethyl sulfoxide, ethylene glycol, a cellosolve-based solvent, a carbitol-based solvent, anisole, and N-methylpyrrolidone. One kind of solvent may be used alone, or two or more kinds thereof may be used in combination.

### 2. Structural body

The structural body according to the present embodiment includes a cured product of the easily dismantlable thermosetting resin composition, which has been described above. The cured product is obtained by thermally curing the resin composition according to the present embodiment at 100°C to 200°C for 10 to 900 seconds.

The structural body can be widely applied to, for example, a composite member for a transport machine such as an automobile, a railway, a ship, or an aircraft, a semiconductor chip, a semiconductor element, a semiconductor device including a printed wiring board, a composite member for a factory equipment such as a working robot, an electric circuit display device, an information communication terminal, a light emitting diode, an electronic device such as a physical battery or a chemical battery, a composite member for civil engineering and construction, and a composite member for sports and recreation. Among these, from the viewpoint of the importance of the response to environmental issues or the like, a composite member for a transport machine such as an automobile, a semiconductor device, or the like is suitable.

Specific examples of the semiconductor device include a semiconductor device including a semiconductor element and a sealing material that seals the semiconductor element, where the sealing material is made of the cured product of the resin composition according to the present embodiment. A sealing method and the like are not particularly limited, and a publicly known method can be used.

### 3. Dismantling method

The dismantling method according to the present embodiment is carried out by immersing the cured product of the above-described easily dismantlable thermosetting resin composition in a solvent. As a result, the crosslinks in the cured product are divided or decomposed, and the cured product is dissolved, or a part of the cured product is dissolved or gelated, whereby the cured product can be dismantled.

An immersion temperature of the cured product can be appropriately set according to the use application; however, it is preferably -20°C to 200°C and more preferably 0°C to 150°C.

In addition, from the viewpoint of carrying out disassembling by a simple method, the immersion of the cured product may be carried out at an environmental temperature, that is, at normal temperature. As a result, special work such as cooling or heating treatment is not necessary. For example, a liquid temperature of the solvent can be set to 5°C to 30°C.

On the other hand, from the viewpoint of the acceleration of the dismantling and the like, the cured product may be subjected to a warming or heating treatment during the immersion of the cured product.

A method of immersing the cured product is not particularly limited, and a part or the whole of the cured product only needs to be brought into contact with a solvent. In addition, the immersion time is appropriately adjusted according to the size or the like of the cured product.

In addition, a solvent may be poured into a container in which the cured product is accommodated, or the cured product may be immersed and stirred in a solvent in a container.

The solvent may be any solvent as long as it is capable of liberating the -Si-O- structure from the cured product, and the solvent is preferably a solvent containing a fluorine ion. The solvent containing a fluorine ion may be a solvent which generates a fluoride ion.

The solvent according to the present embodiment can be, for example, a solvent that is prepared as follows.
(i) A solvent obtained by allowing a fluorine compound of tetra-n-butylammonium fluoride (n-Bu₄NF) to act in an organic solvent such as tetrahydrofuran.
   Examples of the above-described fluorine compound include a fluoride salt of ammonium, an organic amine, or an organic ammonium, and specific examples thereof include one or two or more selected from ammonium fluoride, hydrofluoric acid, acidic ammonium fluoride, a methylamine hydrofluoride salt, an ethylamine hydrofluoride salt, a propylamine hydrofluoride salt, tetramethylammonium fluoride, tetraethylammonium fluoride, an ethanolamine hydrofluoride salt, a methylethanolamine hydrofluoride salt, a dimethylethanolamine hydrofluoride salt, a hydroxylamine hydrofluoride salt, a dimethylhydroxylamine hydrofluoride salt, and a triethylenediamine hydrofluoride salt. Among these, ammonium fluoride and tetra-n-butylammonium fluoride are preferable, and tetra-n-butylammonium fluoride is more preferable.
(ii) A solvent obtained by allowing a mineral acid or an organic strong acid to act in an anhydrous organic solvent such as acetonitrile or a hydrous organic solvent.
(iii) A solvent obtained by allowing N-bromosuccinimide (NBS) to act in dimethyl sulfoxide (DMSO).
(iv) A solvent obtained by allowing a hydrogen sulfate of an alkali metal to act in a solvent such as water or an alcohol.
   As the above-described hydrogen sulfate, an alkali metal salt such as lithium hydrogen sulfate, potassium hydrogen sulfate, or sodium hydrogen sulfate can be used, among which a potassium salt or a sodium salt is particularly suitable.
(v) A solvent obtained by allowing an aqueous acetic acid solution to act.
(vi) A solvent obtained by reacting excess potassium fluoride·dihydrate with excess tetrabutylammonium chloride in acetonitrile.

It is preferable to use, among these solvents, the solvent of (i) from the viewpoint of the decomposition rate and the waste liquid treatment.

### 4. Recycling method

The recycling method according to the present embodiment is a recycling method for a material that constitutes the structural body described above, where the recycling method includes a step of immersing the structural body in a solvent to dismantle the cured product of the easily dismantlable thermosetting resin composition; and a step of recovering the material from the structural body.

As a result, the material that has been used for the structural body can be reused. The step of dismantling the cured product is the same as the method described in the dismantling method.

In addition, a method of recovering the material from the structural body is not particularly limited as long as the quality of the material is not deteriorated, and
examples thereof include a method of precipitating the material in a solvent in which the cured product is dismantled and recovering only the material by filtration or the like, and a method of taking out a structural body from the solvent, and then destroying the structural body together with the cured product which has become brittle by disassembling, thereby recovering the material.

The material is not particularly limited as long as it is insoluble in the above-described solvent and does not cause a chemical reaction, and examples thereof include metals.

As described above, the embodiments of the present invention have been described above; however, these are only examples of the present invention, and thus various configurations other than those above-described can be also employed.

### Examples

Hereinafter, the present invention will be described in detail with reference to examples. However, the content of the present invention is not limited to the examples.

### 1. Synthesis method

Each silyl ether-type phenol resin was synthesized by the following procedure.

### [Synthesis Example 1] (Synthesis method for silyl ether-type phenol monomer)

56.1 g of 2-allylphenol, 80 g of toluene, and 10 µL of Karstedt's catalyst were charged into a flask equipped with a thermometer, a stirrer, and a reflux condenser, and the temperature was raised to 80°C. Thereafter, 28.0 g of 1,1,3,3-tetramethyldisiloxane was added dropwise thereto. Thereafter, the reaction solution was reacted at 80°C for 2 hours, and then toluene was distilled off from the reaction solution. By the above operation, 89.3 g of a silyl ether-type phenol monomer (1) represented by Formula (S1) was obtained.

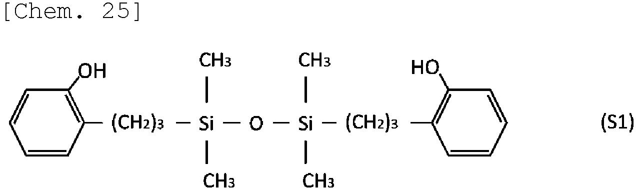

### [Synthesis Example 2] (Synthesis method for silyl ether-type novolac resin (1))

25.0 g of the obtained silyl ether-type phenol monomer (1) and 0.11 g of oxalic acid were charged into a flask equipped with a thermometer, a stirrer, and a reflux condenser, and the temperature was gradually raised. Thereafter, 4.5 g of a 37% formalin solution was added dropwise thereto, and the resultant mixture was reacted at an internal temperature of 100°C for 5 hours. Thereafter, the temperature was raised to an internal temperature of 120°C, and the moisture was removed by carrying out normal pressure dehydration. By the above operation, 27.4 g of a silyl ether-type novolac resin (1) represented by Formula (S2) was obtained.

The silyl ether-type novolac resin (1) had Mn of 780, Mw of 2,800, and a hydroxyl group equivalent of 237 g/eq.

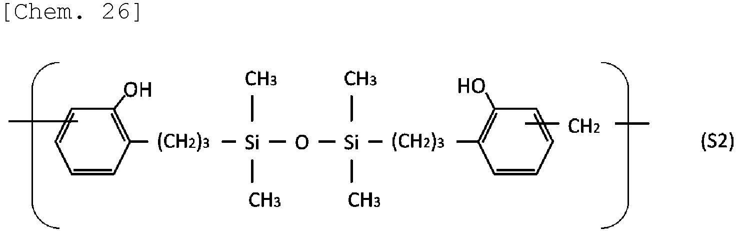

### [Synthesis Example 3] (Synthesis method for silyl ether-type novolac resin (2))

25.0 g of the silyl ether-type phenol monomer (1), 5.8 g of phenol, and 0.22 g of oxalic acid were charged into a flask equipped with a thermometer, a stirrer, and a reflux condenser, and the temperature was gradually raised. Thereafter, 9.0 g of a 37% formalin solution was added dropwise thereto, and the resultant mixture was reacted at an internal temperature of 100°C for 5 hours. Thereafter, the temperature was raised to an internal temperature of 120°C, and the moisture was removed by carrying out normal pressure dehydration. Further, a dehydration reaction was carried out under reduced pressure to obtain 29.5 g of a silyl ether-type novolac resin (2) represented by Formula (S3).

The silyl ether-type novolac resin (2) had Mn of 800, Mw of 2,300, and a hydroxyl group equivalent of 198 g/eq. 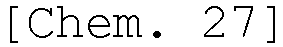 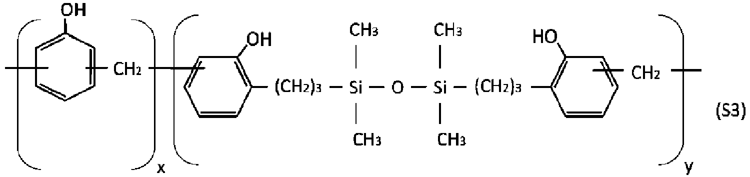 (In Formula (S3), x:y indicates about 45:55.)

### 2. Preparation of resin composition

### <Comparative Examples 1 and 2, and Examples 1 to 4>

Using a raw material I shown below, each of components were mixed according to a ratio in terms of solid content shown in Table 1 to obtain a mixture. The mixing was carried out at normal temperature using a Henschel mixer. Thereafter, the obtained mixture was subjected to roll kneading at 90°C to 120°C to obtain a kneaded product. The obtained kneaded product was cooled and then pulverized to obtain each of resin compositions of Comparative Examples 1 and 2 and Examples 1 to 4.

### [Raw material I]

### (Thermosetting resin)

· Epoxy resin 1: Ortho-cresol novolac-type epoxy resin (manufactured by DIC Corporation, "EPICRON N-670")
· Epoxy resin 2: BPA bisphenol A-type resin (manufactured by Mitsubishi Chemical Corporation, YL6810)

### (Curing agent)

· Curing agent 1: Novolac-type phenol compound (manufactured by Sumitomo Bakelite Co., Ltd., PR-51470)
· Curing agent 2: Silyl ether-type novolac resin (1) obtained in Synthesis Example 2
· Curing agent 3: Silyl ether-type novolac resin (2) obtained in Synthesis Example 3

### (Curing accelerator)

· Curing accelerator 1: Triphenylphosphine

### (Inorganic filler)

· Inorganic filler material 1: Fused spherical silica (manufactured by Denka Company Limited, FB-60)

### (Others)

· Coloring agent 1: Carbon black (manufactured by Mitsubishi Chemical Corporation, CARBON #5)
· Coupling agent 1: N-phenyl-3-aminopropyltrimethoxysilane (manufactured by DuPont Toray Specialty Materials K.K., CF-4083)
· Mold releasing agent 1: Carnauba wax
· Additive: Low stress agent, ion-capturing agent, and flame retardant

### <Example 5>

A silicone rubber-based curable composition was adjusted using a raw material II described below.

First, a mixture obtained by mixing a silicone rubber 1 (80 parts by mass), a silicone rubber 2 (20 parts by mass), a coupling agent 2 (10 parts by mass), a coupling agent 3 (0.5 parts by mass), and water (5.25 parts by mass) was kneaded in advance, and then an inorganic filler 2 (25 parts by mass) was added to the mixture and further kneaded to obtain a kneaded product (silicone rubber compound).

Here, the kneading after the addition of the inorganic filler 2 was carried out by conducting a first step of kneading the mixture for 1 hour under the condition of 60°C to 90°C in a nitrogen atmosphere for a coupling reaction and a second step of kneading the mixture for 2 hours under the condition of 160°C to 180°C in an atmosphere with reduced pressure in order to remove by-products (ammonia), followed by cooling and kneading for 20 minutes.

Subsequently, the silicone rubber 3 and the curing accelerator 2 were added to the obtained kneaded product (silicone rubber compound) so that the proportion (% by mass) shown in Table 1 was obtained, and then the silicone rubber 3 and the curing accelerator 2 were kneaded with a roll to obtain a silicone rubber-based curable composition of Example 5.

### [Raw material II]

### (Silicone rubber; organopolysiloxane (C1))

· Silicone rubber 1 (vinyl group-containing linear organopolysiloxane (C1-2') in which content of vinyl groups is small): synthesized according to synthesis scheme 1. (A structure represented by Formula (C1-2), where the structure has a vinyl group only at R1 (terminal))
· Silicone rubber 2 (vinyl group-containing linear organopolysiloxane (C1-2') in which content of vinyl groups is large): synthesized according to synthesis scheme 2. (A structure represented by Formula (C1-2), where the structure has a vinyl group at R1 and R2)
· Silicone rubber 3 (organohydrogen polysiloxane (C2)) manufactured by Momentive Inc.: "TC-25D"

### (Inorganic filler)

· Inorganic filler 2: Silica particles (particle diameter: 7 nm, specific surface area: 300 m2/g), manufactured by Nippon Aerosil Co., Ltd. "AEROSIL 300"

### (Catalyst and curing accelerator)

· Curing accelerator 2: Platinum compound, manufactured by Momentive Inc.: "TC-25A"

### (Others)

· Silane coupling agent 2: Hexamethyldisilazane (HMDZ), manufactured by Gelest, Inc., "HEXAMETHYLDISILAZANE (SIH 6110.1)"
·Silane coupling agent 3: Divinyltetramethyldisilazane, manufactured by Gelest, Inc., "1,3-DIVINYLTETRAMETHYLDISILAZANE (SID4612.0)"

### <Synthesis of vinyl group-containing organopolysiloxane (C1)>

### [Synthesis Scheme 1: Synthesis of vinyl group-containing linear organopolysiloxane (C1-2') in which content of vinyl groups is small]

A vinyl group-containing linear organopolysiloxane (C1-2') in which a content of vinyl groups is small was synthesized according to Formula (7).

That is, 74.7 g (252 mmol) of octamethylcyclotetrasiloxane and 0.1 g of potassium siliconate were added to a 300 mL separable flask including a cooling tube and a stirring blade, where the separable flask had been subjected to the replacement with Ar gas. The solution was heated and stirred at 120°C for 30 minutes. At this time, an increase in viscosity was observed.

Next, the solution was heated up to 155°C and was continuously stirred for 3 hours. After 3 hours, 0.1 g (0.6 mmol) of 1,3-divinyltetramethyldisiloxane was added and was further stirred at 155°C for 4 hours.

Further, after 4 hours, the solution was diluted with 250 mL of toluene, and was cleaned with water 3 times. After cleaning, the organic layer was cleaned with 1.5 L of methanol and was purified by precipitation to separate an oligomer and a polymer. The obtained polymer was dried under reduced pressure at 60°C overnight to obtain a vinyl group-containing linear organopolysiloxane (C1-2') in which a content of vinyl groups is small (Mn = 2,2 × 105, Mw = 4,8 × 105). In addition, the vinyl group content calculated by H-NMR spectrum measurement was 0.04% by mole.

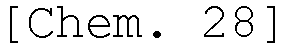

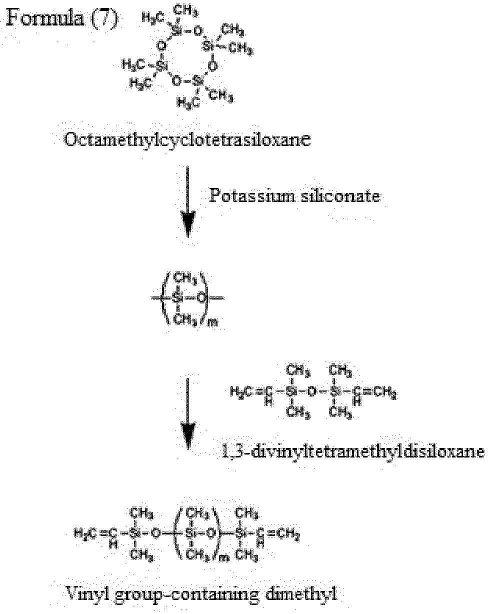

### [Synthesis Scheme 2: Synthesis of vinyl group-containing linear organopolysiloxane (C1-2'')) in which content of vinyl groups is large]

A vinyl group-containing linear organopolysiloxane (C1-2') in which a content of vinyl groups is large was synthesized as shown in Formula (8) by the same synthesis step for (C1-2'), except that 0.86 g (2.5 mmol) of 2,4,6,8-tetramethyl-2,4,6,8-tetravinylcyclotetrasiloxane was used in addition to 74.7 g (252 mmol) of octamethylcyclotetrasiloxane in the synthesis step for (C1-2"). (Mn = 2,3 × 105, Mw = 5,0 × 105). Further, the vinyl group content calculated by H-NMR spectrum measurement was 0.93% by mole.

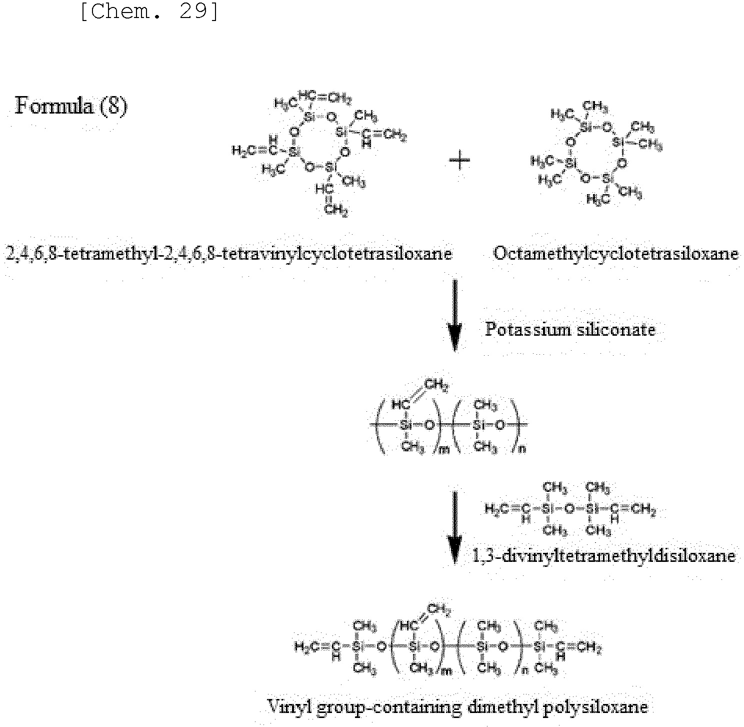

### 3. Checking of structure in cured product of resin composition

In Comparative Examples 1 and 2 and Examples 1 to 4, each of the obtained resin compositions was molded under conditions of a metal mold temperature of 175°C and a curing time of 2 minutes to obtain a cured product. In Example 5, the obtained resin composition was pressed at 160°C and 10 MPa for 20 minutes, was subjected to molding into a sheet shape and primary curing, and subsequently subjected to heating at 200°C for 4 hours and secondary curing, whereby a sheet-shaped silicone rubber cured product was obtained.

Each cured product was subjected to the following resin composition analysis by using thermal decomposition GC-MS. An FT-NMR device (manufactured by JEOL Ltd., JNM-ECA400) was used for the GC-MS measurement.

First, the cured product was heated at 600°C for 1 min in a helium atmosphere, and all the generated components were introduced into a separation column of the GC and trapped with liquid nitrogen. After the heating was completed, the trap was removed, and immediately after the removal of the trap, the GC-MS measurement was started.

The identification of the -Si-O- structure was carried out based on each of the mass spectrum and the retention time, and the determination was carried out according to the following standard. The results are shown in Table 1.

### (Standard)

OK: The -Si-O- structure could be identified.
N/A: The -Si-O- structure could not be identified.

### 4. Evaluation of dismantlability

The dismantlability was evaluated using the following solvent.
· Solvent: Tetrabutylammonium fluoride (0.5 mol/L, THF solution)

First, in Comparative Examples 1 and 2 and Examples 1 to 4, each of the obtained resin compositions was molded under conditions of a metal mold temperature of 175°C and a curing time of 2 minutes to obtain a cured product (width: 10 mm, thickness: 4 mm, length: 20 mm). In Example 5, the obtained resin composition was pressed at 160°C and 10 MPa for 20 minutes, was subjected to molding into a sheet shape and primary curing, and subsequently subjected to heating at 200°C for 4 hours and secondary curing, whereby a sheet-shaped silicone rubber cured product (width: 10 mm, thickness: 4 mm, length: 20 mm) was obtained.

Next, the obtained cured product was immersed in 25 ml of a solvent in a container and allowed to stand at 23°C for 24 hours.

Thereafter, the container was shaken as it was for 1 minute using a shaker (about 200 reciprocations/minute), and then the entire solution in the container was filtered through a 212 µm mesh filter (JIS standard sieve: 212 µm, diameter: 100 mm). The success or failure of the filtration (the presence or absence of the clogging of the filter) and the residue on the filter were observed and evaluated according to the following standard. It indicates that the lower the degree of clogging of the filter is and the smaller the residue is, the better the cured product can be dissolved in the solvent and the more favorable the dismantlability is. The results are shown in Table 1.

### (Standard)

A: The filter was not clogged, and there was no residue of the cured product or a small amount of a residue of the cured product was present on the filter.
B: Although the filter was not clogged, a residue of the cured product was remarkably present on the filter.
C: The filter was directly clogged, and the filtration was not possible.

**[Table 1]**

| | | Unit | Comparative Example 1 | Comparative Example 2 | Example 1 | Example 2 | Example 3 | Example 4 | Example 5 |
|---|---|---|---|---|---|---|---|---|---|
| Thermosetting resin | Epoxy resin 1 | % by mass | 12.10 | | | | | | |
| | Epoxy resin 2 | | | 10.77 | 7.24 | 8.12 | 4.37 | 10.11 | |
| Curing agent | Curing agent 1 | | 5.25 | 6.53 | | | | | |
| | Curing agent 2 | | | | 10.06 | | 6.07 | 14.05 | |
| | Curing agent 3 | | | | | 9.18 | | | |
| Silicone rubber | Silicone rubber 1 | | | | | | | | 55.55 |
| | Silicone rubber 2 | | | | | | | | 13.89 |
| | Silicone rubber 3 | | | | | | | | 1.77 |
| Curing accelerator | Curing accelerator 1 | | 0.30 | 0.35 | 0.35 | 0.35 | 0.21 | 0.49 | |
| | Curing accelerator 2 | | | | | | | | 0.49 |
| Inorganic filler | Inorganic filler 1 | | 80.00 | 80.00 | 80.00 | 80.00 | 87.00 | 73.00 | |
| | Inorganic filler 2 | | | | | | | | 17.36 |
| Others | Coloring agent 1 | | 0.30 | 0.30 | 0.30 | 0.30 | 0.30 | 0.30 | |
| | Coupling agent 1 | | 0.20 | 0.20 | 0.20 | 0.20 | 0.20 | 0.20 | |
| | Coupling agent 2 | | | | | | | | 6.94 |
| | Coupling agent 3 | | | | | | | | 0.35 |
| | Mold releasing agent 1 | | 0.30 | 0.30 | 0.30 | 0.30 | 0.30 | 0.30 | |
| | Additive | | 1.55 | 1.55 | 1.55 | 1.55 | 1.55 | 1.55 | |
| | Water | | | | | | | | 3.65 |
| Total | | | 100 | 100 | 100 | 100 | 100 | 100 | 100 |
| Analysis | GC-MS Identification of -Si-O-structure | | N/A | N/A | OK | OK | OK | OK | OK |
| Evaluation | Dismantlability | Solvent | C | C | A | A | A | A | A |

This application claims priority on the basis of Patent Application No. 2022-088784 filed on May 31, 2022, the entire disclosure of which is incorporated herein by reference.

## Claims

1. An easily dismantlable thermosetting resin composition comprising:
a thermosetting component,
wherein a cured product which is obtained by thermally curing the easily dismantlable thermosetting resin composition has a structure represented by Formula (1), 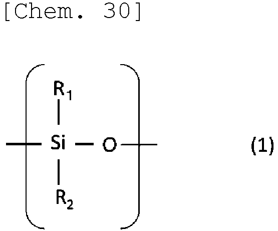
(In Formula (1), R₁ and R₂ each independently represent any of a hydrogen atom, a hydrocarbon group or aromatic group having 1 to 30 carbon atoms, a hydroxyl group, and an alkoxyl group having 1 to 30 carbon atoms)

2. The easily dismantlable thermosetting resin composition according to Claim 1,
wherein the thermosetting component has an -Si-O-structure.

3. The easily dismantlable thermosetting resin composition according to Claim 1 or 2,
wherein the thermosetting component contains a thermosetting resin and a curing agent, and both the thermosetting component and the curing agent have an -Si-O-structure.

4. The easily dismantlable thermosetting resin composition according to Claim 1 or 2,
wherein the thermosetting component contains a thermosetting resin and a curing agent, and the curing agent has an -Si-O- structure.

5. The easily dismantlable thermosetting resin composition according to Claim 3,
wherein the curing agent includes a phenol-based curing agent.

6. The easily dismantlable thermosetting resin composition according to Claim 1 or 2,
wherein the thermosetting component contains a thermosetting resin and a curing agent, and the thermosetting resin has an -Si-O- structure.

7. The easily dismantlable thermosetting resin composition according to Claim 6,
wherein the thermosetting resin includes one or two or more resins selected from an epoxy resin, a phenoxy resin, a polyimide resin, a benzoxazine resin, an unsaturated polyester resin, a phenol resin, a melamine resin, a silicone resin, a cyanate resin, a bismaleimide resin, and an acrylic resin.

8. The easily dismantlable thermosetting resin composition according to Claim 7,
wherein the thermosetting resin includes an epoxy resin.

9. The easily dismantlable thermosetting resin composition according to Claim 1 or 2, further comprising:
an inorganic filler,
wherein a content of the inorganic filler is 10% by mass to 98% by mass with respect to a total amount of the easily dismantlable thermosetting resin composition.

10. The easily dismantlable thermosetting resin composition according to Claim 1 or 2,
wherein the easily dismantlable thermosetting resin composition contains a silyl ether-modified novolac resin.

11. The easily dismantlable thermosetting resin composition according to Claim 1 or 2,
wherein the easily dismantlable thermosetting resin composition contains a phenol resin having a weight average molecular weight (Mw) of 500 to 10,000.

12. A structural body comprising:
a cured product of the easily dismantlable thermosetting resin composition according to Claim 1 or 2.

13. A semiconductor device comprising:
a semiconductor element; and
a sealing material that seals the semiconductor element,
wherein the sealing material consists of the cured product of the easily dismantlable thermosetting resin composition according to Claim 1 or 2.

14. A dismantling method that is a dismantling method for the cured product of the easily dismantlable thermosetting resin composition according to Claim 1 or 2, the dismantling method comprising:
a step of immersing the cured product of the easily dismantlable thermosetting resin composition in a solvent to dismantle the cured product.

15. The dismantling method according to Claim 14,
wherein the solvent is a solvent containing a fluorine ion.

16. The dismantling method according to Claim 14,
wherein the immersion is carried out at -20°C to 200°C.

17. The dismantling method according to Claim 14,
wherein the immersion is carried out at 5°C to 30°C.

18. A recycling method for a material that constitutes the structural body according to Claim 12, the recycling method comprising:
a step of immersing the structural body in a solvent to dismantle the cured product of the easily dismantlable thermosetting resin composition; and
a step of recovering the material from the structural body.
